# EUROPEAN PATENT APPLICATION

(11) **EP 4 615 199 A1**
(43) Date of publication of application: **10.09.2025**
(21) Application number: 25153111.7
(22) Date of filing: 21.01.2025
(51) Int. Cl.: H10H 20/811, H10H 20/814, H10H 20/83, H10H 20/831, H10H 20/84

(54) **LIGHT-EMITTING DEVICE AND DISPLAY DEVICE INCLUDING THE SAME**

(30) Priority: 07.03.2024 KR 20240032842
(71) Applicant: Samsung Electronics Co., Ltd., Suwon-si, Gyeonggi-do 16677 (KR)
(72) Inventor: JEAN, Jaiwon, 16677 Suwon-si, Gyeonggi-do (KR); KIM, Minje, 16677 Suwon-si, Gyeonggi-do (KR); SOHN, Yuri, 16677 Suwon-si, Gyeonggi-do (KR); AHN, Minjoo, 16677 Suwon-si, Gyeonggi-do (KR); JUNG, Soojin, 16677 Suwon-si, Gyeonggi-do (KR); CHUN, Daemyung, 16677 Suwon-si, Gyeonggi-do (KR); HA, Sangwoo, 16677 Suwon-si, Gyeonggi-do (KR)
(74) Representative: Kuhnen & Wacker Patent- und Rechtsanwaltsbüro PartG mbB

(57) **Abstract**

A light-emitting device (100) is provided. The light-emitting device (100) includes: a semiconductor light-emitting structure (110) including a first conductivity type semiconductor layer (112), an active layer (114), and a second conductivity type semiconductor layer (116) which are sequentially provided in a first direction (Z); and an electrode layer (130, 170) covering the second conductivity type semiconductor layer (116) and spaced apart from the active layer (114) in the first direction (Z) with the second conductivity type semiconductor layer (116) therebetween. The semiconductor light-emitting structure (110) is configured to emit light having a wavelength λ within a range from about 490 nm to about 700 nm. A minimum distance from the electrode layer (130, 170) to the active layer (114) in the first direction (Z) is greater than about 0.05λ and less than about 0.24λ.

## Description

### BACKGROUND

The present disclosure relates to a light-emitting device and a display device including the same, and more particularly, to a light-emitting device including an active layer and a display device including the light-emitting device.

Light-emitting diodes (LEDs) are light sources which convert electrical energy into optical energy and are widely used as a light source for various display devices, such as a lighting system, a television, a mobile phone, a personal computer, a laptop computer, a personal digital assistant (PDA), a digital camera, a camcorder, a viewfinder, a micro display, a three-dimensional (3D) display, a virtual reality or augmented reality display, etc. Recently, micro- or nano-scale subminiature LEDs using II-VI group or III-V group compound semiconductors have been developed, and accordingly, there has been a growing demand for a light-emitting device having a novel structure to improve light extraction efficiency in such subminiature LEDs.

### SUMMARY

One or more embodiments provide a light-emitting device having a structure capable of improving the light extraction efficiency.

One or more embodiments also provide a display device including a light-emitting device having a structure capable of improving the light extraction efficiency.

According to an aspect of an embodiment, a light-emitting device includes: a semiconductor light-emitting structure including a first conductivity type semiconductor layer, an active layer, and a second conductivity type semiconductor layer which are sequentially provided in a first direction; and an electrode layer covering the second conductivity type semiconductor layer and spaced apart from the active layer in the first direction with the second conductivity type semiconductor layer therebetween, wherein the semiconductor light-emitting structure is configured to emit light having a wavelength (λ) within a range from about 490 nm to about 700 nm, and wherein a minimum distance from the electrode layer to the active layer in the first direction is greater than about 0.05λ and less than about 0.24λ.

According to another aspect of an embodiment, a light-emitting device includes: a first conductivity type base semiconductor layer; a semiconductor light-emitting structure including a first conductivity type semiconductor layer, an active layer, and a second conductivity type semiconductor layer which are sequentially provided on a main surface of the first conductivity type base semiconductor layer in a first direction perpendicular to the main surface; a first electrode surrounding a side wall of the first conductivity type base semiconductor layer; a transparent electrode layer covering the second conductivity type semiconductor layer and spaced apart from the active layer in the first direction with the second conductivity type semiconductor layer therebetween; a reflective structure covering a side wall of each of the semiconductor light-emitting structure and the transparent electrode layer; a second electrode in contact with the transparent electrode layer and spaced apart from the second conductivity type semiconductor layer in the first direction with the transparent electrode layer therebetween; and a microlens in contact with an emission surface including a part of a rear surface opposite to the main surface of the first conductivity type base semiconductor layer and configured to collect and emit light from the semiconductor light-emitting structure. The semiconductor light-emitting structure is configured to emit light having a wavelength (λ) within a range from about 490 nm to about 700 nm. The semiconductor light-emitting structure has a width of 100 µm or less in a second direction parallel with the main surface of the first conductivity type base semiconductor layer. A minimum distance from the active layer to the transparent electrode layer in the first direction is greater than 0.05λ and less than 0.24λ. The active layer includes at least one multi-quantum well layer. A thickness of the at least one multi-quantum well layer in the first direction is less than 300 nm.

According to another aspect of an embodiment, a display device includes: a circuit board including a driver circuit; and a pixel array on the circuit board and including a plurality of pixels. The pixel array includes: a first conductivity type base semiconductor layer including a main surface and a rear surface which are opposite to each other; a plurality of semiconductor light-emitting structures on the main surface of the first conductivity type base semiconductor layer and spaced apart from each other in a horizontal direction parallel with the main surface, each of the plurality of semiconductor light-emitting structures including a first conductivity type semiconductor layer, an active layer, and a second conductivity type semiconductor layer which are sequentially provided in a first direction perpendicular to the main surface; a first electrode including a metal layer having a grid shape penetrating the first conductivity type base semiconductor layer in the first direction; a plurality of transparent electrode layers covering the second conductivity type semiconductor layer in each of the plurality of semiconductor light-emitting structures; a reflective structure covering a side wall of each of the plurality of semiconductor light-emitting structures and the plurality of transparent electrode layers; a plurality of second electrodes penetrating the reflective structure in the first direction and in contact with one transparent electrode layer selected from the plurality of transparent electrode layers; and a plurality of microlenses on the rear surface of the first conductivity type base semiconductor layer and overlapping the plurality of semiconductor light-emitting structures in the first direction. At least one semiconductor light-emitting structure selected from the plurality of semiconductor light-emitting structures is configured to emit light having a wavelength (λ) within a range from about 490 nm to about 700 nm. In the at least one semiconductor light-emitting structure, a minimum distance from the active layer to a transparent electrode layer, from among the plurality of transparent electrode layers, in the first direction is greater than about 0.05λ and less than about 0.24λ.

### BRIEF DESCRIPTION OF DRAWINGS

The above and other aspects will be more apparent from the following description of embodiments, taken in conjunction with the accompanying drawings, in which:
FIG. 1 is a cross-sectional view illustrating a schematic structure of a light-emitting device according to some embodiments;
FIG. 2A is a schematic perspective view illustrating examples of shapes of a semiconductor light-emitting structure and a transparent electrode layer according to some embodiments, and FIG. 2B is a schematic plan view illustrating the semiconductor light-emitting structure of FIG. 2A according to some embodiments;
FIG. 3A is a schematic perspective view illustrating examples of shapes of a semiconductor light-emitting structure and a transparent electrode layer which are included in a light-emitting device according to some embodiments, and FIG. 3B is a schematic plan view illustrating a plane shape of the semiconductor light-emitting structure of FIG. 3A according to some embodiments;
FIGS. 4 and 5 illustrate schematic plan views of example plane shapes of a semiconductor light-emitting structures included in light-emitting devices according to some embodiments;
FIGS. 6, 7, and 8 illustrate cross-sectional views of light-emitting devices according to some embodiments;
FIG. 9A is a cross-sectional view illustrating a light-emitting device according to some embodiments, and FIG. 9B is an enlarged cross-sectional view illustrating a part denoted by "EX1" in FIG. 9A according to some embodiments;
FIG. 10 is a view illustrating a relation between a change in light extraction efficiency according to position of an active layer of a semiconductor light-emitting structure included in the light-emitting device of FIGS. 9A and 9B and a position of each of a first multi-quantum well layer and a second multi-quantum well layer which are included in the active layer;
FIG. 11 is a schematic perspective view illustrating a display device according to some embodiments, FIG. 12 is an enlarged plan view illustrating a part denoted by "EX2" in FIG. 11 according to some embodiments, and FIG. 13 is a cross-sectional view schematically illustrating components of a portion along a cross-section cut by line I-I' in FIG. 11 and a portion along a cross-section cut by line II-II' in FIG. 12 according to some embodiments;
FIGS. 14 and 15 each illustrate a graph showing an simulation result for evaluation of light extraction efficiency of a light-emitting device according to some embodiments;
FIGS. 16, 17, and 18 each illustrate a graph showing an simulation result for evaluation of light extraction efficiency of a light-emitting device according to some embodiments;
FIGS. 19A, 19B, 19C, 19D, 19E, 19F and 19G each show a cross-sectional view illustrating a method of manufacturing a display device including a light-emitting device according to a process order, according some embodiments;
FIG. 20 is a block diagram illustrating an example of an electronic device including a display device or a light-emitting device according some embodiments;
FIG. 21 is a view illustrating an example of a mobile device as an application example of an electronic device including a display device or a light-emitting device according some embodiments;
FIG. 22 is a view illustrating an example of a head-up display device for vehicles as an application example of an electronic device including a display device or a light-emitting device according some embodiments;
FIG. 23 is a view illustrating an example of augmented reality glasses or virtual reality glasses as an application example of an electronic device including a display device or a light-emitting device according some embodiments;
FIG. 24 is a view illustrating an example of a large-scale signage as an application example of an electronic device including a display device or a light-emitting device according some embodiments; and
FIG. 25 is a view illustrating an example of a wearable display as an application example of an electronic device including a display device or a light-emitting device according some embodiments.

### DETAILED DESCRIPTION

Hereinafter, embodiments of the inventive concept are described in detail with reference to the accompanying drawings. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. It will be also understood that, even if a certain step or operation of manufacturing an apparatus or structure is described later than another step or operation, the step or operation may be performed before the other step or operation unless the step or operation is described as being performed after the other step or operation. In the drawings, like reference numerals denote like components, and any redundant description thereon will be omitted.

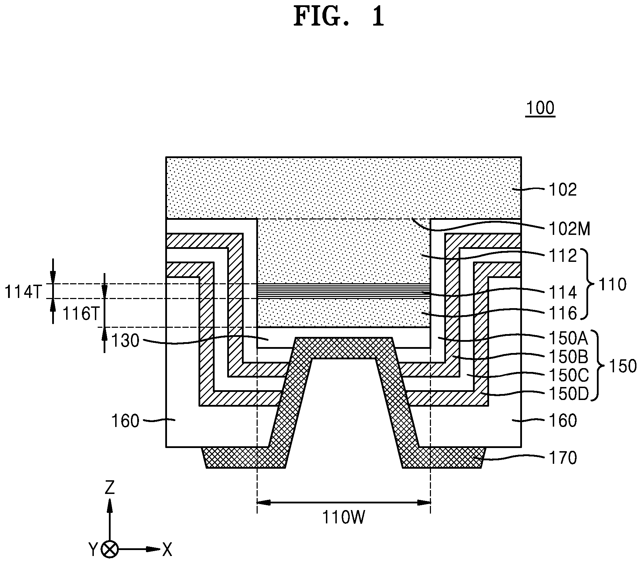

FIG. 1 is a cross-sectional view illustrating a schematic structure of a light-emitting device 100 according to some embodiments.

Referring to FIG. 1, the light-emitting device 100 may include a first conductivity type base semiconductor layer 102 and a semiconductor light-emitting structure 110 arranged on a main surface 102M of the first conductivity type base semiconductor layer 102. The semiconductor light-emitting structure 110 may include a first conductivity type semiconductor layer 112, an active layer 114, and a second conductivity type semiconductor layer 116, which are sequentially stacked on the main surface 102M in a first direction (Z direction in FIG. 1) perpendicular to the main surface 102M of the first conductivity type base semiconductor layer 102.

The semiconductor light-emitting structure 110 may include a micro light-emitting diode (LED). In some embodiments, the semiconductor light-emitting structure 110 may include a micro LED which generates light having a color selected from red, green, and blue. The term "micro LED" as used herein refers to a LED having a width of 100 µm or less in a horizontal direction (e.g., X direction in FIG. 1) perpendicular to the first direction (Z direction in FIG. 1). For example, the width of the semiconductor light-emitting structure 110 in the horizontal direction (e.g., X direction in FIG. 1) may be about 100 µm or less, about 50 µm or less, about 20 µm or less, about 10 µm or less, about 6 µm or less, about 5 µm or less, about 4 µm or less, or about 2 µm or less; however, embodiments are not limited thereto.

The semiconductor light-emitting structure 110 may be configured to emit light having a wavelength (λ) within a range from about 400 nm to about 700 nm.

In some embodiments, the semiconductor light-emitting structure 110 may be configured to emit light having a first wavelength (λ1) within a range from about 580 nm to about 700 nm. The light having the first wavelength (λ1) may be red light. As used herein, the wavelength region of red light refers to a wavelength region of about 580 nm or more and less than about 700 nm, for example, a wavelength region from about 610 nm to about 650 nm or a wavelength region from about 620 nm to about 640 nm, and there may be at least one emission spectrum peak in the wavelength region of red light.

In some embodiments, the semiconductor light-emitting structure 110 may be configured to emit light having a second wavelength (λ2) within a range from about 490 nm to about 580 nm. The light having the second wavelength (λ2) may be green light. As used herein, the wavelength region of green light refers to a wavelength region of about 490 nm or more and less than about 580 nm, for example, a wavelength region from about 510 nm to about 550 nm or a wavelength region from about 520 nm to about 540 nm, and there may be at least one emission spectrum peak in the wavelength region of green light.

In some embodiments, the semiconductor light-emitting structure 110 may be configured to emit light having a third wavelength (λ3) within a range from about 400 nm to about 490 nm. The light having the third wavelength (λ3) may be blue light. As used herein, the wavelength region of blue light refers to a wavelength region of about 400 nm or more and less than about 490 nm, for example, a wavelength region from about 440 nm to about 480 nm or a wavelength region from about 450 nm to about 470 nm, and there may be at least one emission spectrum peak in the wavelength region of blue light.

Each of the first conductivity type base semiconductor layer 102, the first conductivity type semiconductor layer 112, the active layer 114, and the second conductivity type semiconductor layer 116 may include an epitaxial nitride semiconductor layer. The first conductivity type base semiconductor layer 102 and the first conductivity type semiconductor layer 112 may include a nitride semiconductor layer doped with the same type of dopant, e.g., n-type dopant, and an average doping concentration of the first conductivity type base semiconductor layer 102 may be higher than an average doping concentration of the first conductivity type semiconductor layer 112. Each of the first conductivity type semiconductor layer 112 and the second conductivity type semiconductor layer 116 may include a single layer or include multiple layers including a plurality of layers having different doping concentrations of dopant, compositions of constituent components, etc., from each other. The first conductivity type base semiconductor layer 102 may be spaced apart from the active layer 114 in the first direction (Z direction in FIG. 1) with the first conductivity type semiconductor layer 112 arranged therebetween.

The first conductivity type base semiconductor layer 102 may have a thickness of about 10 nm to about 6,000 nm in the first direction (Z direction in FIG. 1). The first conductivity type semiconductor layer 112 may have a thickness of about 10 nm to about 500 nm in the first direction.

In the semiconductor light-emitting structure 110, the first conductivity type semiconductor layer 112 may be integrally connected to the first conductivity type base semiconductor layer 102. In some embodiments, the first conductivity type base semiconductor layer 102 and the first conductivity type semiconductor layer 112 may include the same material. In some embodiments, the first conductivity type base semiconductor layer 102 may include an n-type gallium nitride (n-GaN). The first conductivity type semiconductor layer 112 may include an n-type superlattice structure layer. For example, the first conductivity type semiconductor layer 112 may include an InGaN/GaN superlattice structure layer. In this case, the first conductivity type semiconductor layer 112 may have a superlattice structure in which an InGaN film and a GaN film are alternately stacked. In the first conductivity type semiconductor layer 112, the superlattice structure may include a pair structure of an InGaN film and a GaN film in about 10 cycles to about 50 cycles, for example, about 15 cycles to about 20 cycles; however, embodiments are not limited thereto.

In some embodiments, the first conductivity type semiconductor layer 112 may include a nitride semiconductor layer having a composition of InₓAl_{y}Ga_{1-x-y}N (0≤x<1, 0≤y<1, 0≤x+y<1). In some embodiments, the first conductivity type semiconductor layer 112 may include an n-type gallium nitride (n-GaN) doped with silicon (Si), germanium (Ge), or carbon (C). In some embodiments, the first conductivity type semiconductor layer 112 may be a semiconductor layer including aluminum indium gallium phosphide (AlInGaP) or aluminum indium gallium arsenide (AlInGaAs).

In the semiconductor light-emitting structure 110, the active layer 114 may emit light having certain energy by recombination of electrons and holes. The active layer 114 may have a single-quantum well or multi-quantum well structure in which a quantum barrier layer and a quantum well layer are arranged alternately. In some embodiments, the active layer 114 may have a single- or multi-quantum well structure including a pair structure of one quantum barrier layer and one quantum well layer in 1 to 15 cycles.

In some embodiments, the active layer 114 may include a quantum barrier layer and a quantum well layer including a compound semiconductor of III-V group elements. For example, the active layer 114 may include a pair structure selected from InGaN/GaN, InGaN/InGaN, InGaN/AlGaN, and InGaN/InAlGaN; however, embodiments are not limited thereto.

In some embodiments, the quantum well layer and the quantum barrier layer may respectively include InₓAl_{y}Ga_{1-x-y}N layers (0≤x≤1, 0≤y≤1, 0≤x+y≤1) having different compositions from each other. For example, the quantum well layer may include an undoped InₓGa₁₋ₓN layer (0<x<1), and the quantum barrier layer may include an undoped GaN layer or a GaN layer doped with silicon (Si).

In some embodiments, when the quantum barrier layer included in the active layer 114 is an InₓGa₁₋ₓN layer (0<x<1), the bandgap energy at the active layer 114 may be controlled according to a content ratio of indium (In) in the quantum well layer, thereby controlling an emission wavelength band. When the quantum well layer included in the active layer 114 is an InₓGa₁₋ₓN layer (0<x<1), a value of x, which represents a content ratio of indium (In) in the quantum well layer, may be within a range from about 0.15 to about 0.35. For example, when the semiconductor light-emitting structure 110 is configured to emit red light, the x value in the InₓGa₁₋ₓN layer (0<x<1) constituting the quantum well layer included in the active layer 114 may be within a range from about 0.3 to about 0.35, when the semiconductor light-emitting structure 110 is configured to emit green light, the x value in the InₓGa₁₋ₓN layer (0<x<1) constituting the quantum well layer included in the active layer 114 may be within a range from about 0.25 to about 0.3, and when the semiconductor light-emitting structure 110 is configured to emit blue light, the x value in the InₓGa₁₋ₓN layer (0<x<1) constituting the quantum well layer included in the active layer 114 may be within a range from about 0.15 to about 0.2; however, embodiments are not limited thereto.

In the first direction (Z direction in FIG. 1), a thickness 114T of the active layer 114 may be less than 300 nm. As illustrated in FIG. 1, the active layer 114 may include a surface in contact with the first conductivity type semiconductor layer 112 and a surface in contact with the second conductivity type semiconductor layer 116, and in the active layer 114, a minimum distance from the surface in contact with the first conductivity type semiconductor layer 112 to the surface in contact with the second conductivity type semiconductor layer 116 may be less than 300 nm.

In some embodiments, the active layer 114 may include a multi-quantum well layer including a pair structure of one quantum barrier layer and one quantum well layer in 8 to 12 cycles, wherein the multi-quantum well layer may include a surface in contact with the first conductivity type semiconductor layer 112 and a surface in contact with the second conductivity type semiconductor layer 116, and in the first direction, the multi-quantum well layer may have a thickness less than 300 nm.

In some embodiments, the thickness 114T of the active layer 114 may be less than 300 nm, less than 200 nm, less than 100 nm, less than 50 nm, less than 40 nm, less than 20 nm, less than 10 nm, less than 5 nm, or less than 3 nm. For example, the thickness 114T of the active layer 114 may be within a range from about 2 nm to about 10 nm; however, embodiments are not limited thereto.

In some embodiments, the thickness 114T of the active layer 114 may be determined according to a wavelength (λ) of light emitted from the semiconductor light-emitting structure 110, and the thickness 114T of the active layer 114 may be less than 0.4λ. In an embodiment, when the semiconductor light-emitting structure 110 is configured to emit red light having a first wavelength (λ1) within a range from about 580 nm to about 700 nm, the thickness 114T of the active layer 114 may be less than 0.4λ1. In another embodiment, when the semiconductor light-emitting structure 110 is configured to emit green light having a second wavelength (λ2) within a range from about 490 nm to about 580 nm, the thickness 114T of the active layer 114 may be less than 0.4λ2. In another embodiment, when the semiconductor light-emitting structure 110 is configured to emit blue light having a third wavelength (λ3) within a range from about 400 nm to about 490 nm, the thickness 114T of the active layer 114 may be less than 0.4λ3.

In the semiconductor light-emitting structure 110, the second conductivity type semiconductor layer 116 may include a nitride semiconductor layer doped with a p-type dopant. In some embodiments, the second conductivity type semiconductor layer 116 may include a nitride semiconductor layer having a composition of InₓAl_{y}Ga_{1-x-y}N (0≤x<1, 0≤y<1, 0≤x+y<1). For example, the second conductivity type semiconductor layer 116 may include a p-type gallium nitride (p-GaN) doped with magnesium (Mg) or zinc (Zn). However, embodiments are not limited thereto. In some embodiments, the second conductivity type semiconductor layer 116 may be a semiconductor layer including aluminum indium gallium phosphide (AlInGaP) or aluminum indium gallium arsenide (AlInGaAs).

The light-emitting device 100 may include a transparent electrode layer 130 covering the second conductivity type semiconductor layer 116 and a reflective electrode layer 170. The transparent electrode layer 130 may be arranged to be in contact with the second conductivity type semiconductor layer 116 and spaced apart from the active layer 114 in the first direction (Z direction in FIG. 1) with the second conductivity type semiconductor layer 116 arranged therebetween. The reflective electrode layer 170 may be arranged to be in contact with the transparent electrode layer 130 and spaced apart from the second conductivity type semiconductor layer 116 in the first direction (Z direction in FIG. 1) with the transparent electrode layer 130 arranged therebetween. The transparent electrode layer 130 may be referred to as an electrode layer, and the reflective electrode layer 170 may be referred to as an electrode layer or a second electrode.

In the first direction, a minimum distance from the reflective electrode layer 170 to the active layer 114 may be determined according to a wavelength (λ) of light emitted from the semiconductor light-emitting structure 110. The minimum distance from the reflective electrode layer 170 to the active layer 114 in the first direction may be greater than 0.05λ and less than 0.4λ. In some embodiments, the minimum distance from the reflective electrode layer 170 to the active layer 114 in the first direction may be greater than 0.05λ and less than 0.24λ.

As illustrated in FIG. 1, the second conductivity type semiconductor layer 116 may include a surface in contact with the active layer 114 and a surface in contact with the transparent electrode layer 130, and in the second conductivity type semiconductor layer 116, the surface in contact with the active layer 114 may be opposite to the surface in contact with the transparent electrode layer 130 in the first direction. As such, when the second conductivity type semiconductor layer 116 is arranged between the active layer 114 and the transparent electrode layer 130, and in contact with each of the active layer 114 and the transparent electrode layer 130, the minimum distance from the transparent electrode layer 130 to the active layer 114 in the first direction may correspond to a thickness 116T of the second conductivity type semiconductor layer 116 in the first direction, and the thickness 116T of the second conductivity type semiconductor layer 116 may be greater than 0.05λ and less than 0.4λ. In some embodiments, the thickness 116T of the second conductivity type semiconductor layer 116 in the first direction may be greater than 0.05λ and less than 0.24λ.

When the semiconductor light-emitting structure 110 is configured to emit red light having a first wavelength (λ1) within a range from about 580 nm to about 700 nm, the thickness 116T of the second conductivity type semiconductor layer 116 in the first direction may be greater than 0.05λ and less than 0.24λ, for example, greater than 0.1λ and less than 0.24λ. For example, the thickness 116T of the second conductivity type semiconductor layer 116 may be about 29 nm to about 210 nm, about 31 nm to about 180 nm, about 63 nm to about 152 nm, or about 95 nm to about 135 nm; however, embodiments are not limited thereto.

When the semiconductor light-emitting structure 110 is configured to emit green light having a second wavelength (λ2) within a range from about 490 nm to about 580 nm, the thickness 116T of the second conductivity type semiconductor layer 116 in the first direction may be greater than 0.05λ and less than 0.24λ, for example, greater than 0.1λ and less than 0.24λ. For example, the thickness 116T of the second conductivity type semiconductor layer 116 may be about 24 nm to about 174 nm, about 26 nm to about 159 nm, about 53 nm to about 128 nm, or about 60 nm to about 100 nm; however, embodiments are not limited thereto.

When the semiconductor light-emitting structure 110 is configured to emit blue light having a third wavelength (λ3) within a range from about 400 nm to about 490 nm, the thickness 116T of the second conductivity type semiconductor layer 116 in the first direction may be greater than 0.05λ and less than 0.4λ, for example, greater than 0.2λ and less than 0.4λ. For example, the thickness 116T of the second conductivity type semiconductor layer 116 may be about 80 nm to about 196 nm, about 23 nm to about 184 nm, about 92 nm to about 184 nm, or about 125 nm to about 165 nm; however, embodiments are not limited thereto.

The semiconductor light-emitting structure 110 may have a cylindrical shape having a center axis extending in the first direction. The semiconductor light-emitting structure 110 may have a width 110W less than 100 µm in a second direction (e.g., X direction in FIG. 1) perpendicular to the first direction. In some embodiments, the width 110W of the semiconductor light-emitting structure 110 may be about 100 nm to about 10 µm or about 500 nm to about 1,500 nm.

The transparent electrode layer 130 may have a width identical or similar to the width 110W of the semiconductor light-emitting structure 110 in the second direction (e.g., X direction in FIG. 1). In the first direction, the transparent electrode layer 130 may have a variable thickness. In the transparent electrode layer 130, a thickness of a portion in contact with the reflective electrode layer 170 in the first direction may be less than thicknesses of other portions of the transparent electrode layer 130. In some embodiments, a maximum thickness of the transparent electrode layer 130 in the first direction may be about 50 nm to about 150 nm, and the width of the portion of the transparent electrode layer 130 in contact with the reflective electrode layer 170 may be about 30 nm to about 70 nm; however, embodiments are not limited thereto.

The transparent electrode layer 130 may include a transparent conductive material. In some embodiments, the transparent electrode layer 130 may include indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), zinc magnesium oxide (In₄Sn₃O₁₂, Zn₍₁₋ₓ₎MgₓO, 0≤x≤1), or a combination thereof. In the second direction, the thickness of the transparent electrode layer 130 may be about 1 nm to about 100 nm, for example, about 7 nm to about 20 nm; however, embodiments are not limited thereto.

The reflective electrode layer 170 may include silver (Ag), nickel (Ni), aluminum (Al), chrome (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof; however, embodiments are not limited thereto.

In a plan view (X-Y plane in FIG. 1), the semiconductor light-emitting structure 110 may have various plane shapes. For example, the plane shape of the semiconductor light-emitting structure 110 may be a circular shape, an elliptical shape, or a polygonal shape. The polygonal shape may be a tetragonal shape, a hexagonal shape, or an octagonal shape; however, embodiments are not limited thereto. In a plan view (X-Y plane in FIG. 1), a plane shape of the transparent electrode layer 130 and a plane shape of the semiconductor light-emitting structure 110 may correspond to each other. The semiconductor light-emitting structure 110 and the transparent electrode layer 130 may form a cylindrical shape.

A side wall of each of the first conductivity type semiconductor layer 112, the active layer 114, and the second conductivity type semiconductor layer 116 which are included in the semiconductor light-emitting structure 110 and a side wall of the transparent electrode layer 130 may be covered by a reflective structure 150. In plan view (X-Y plane in FIG. 1), the semiconductor light-emitting structure 110 and the transparent electrode layer 130 may be surrounded by the reflective structure 150. The reflective structure 150 may include a distributed Bragg reflector (DBR). As illustrated in FIG. 1, the reflective structure 150 may have a DBR structure in which a first insulating layer 150A, a second insulating layer 150B, a third insulating layer 150C, and a fourth insulating layer 150D are sequentially stacked. In this regard, the first insulating layer 150A and the third insulating layer 150C may include a first insulating material, and the second insulating layer 150B and the fourth insulating layer 150D may include a second insulating material. The first insulating material and the second insulating material may have different refractive indexes from each other. In some embodiments, the first insulating material and the second insulating material may include different materials from each other, and the first insulating material and the second insulating material may each be selected from SiO₂, SiON, TiO₂, Si₃N₄, Al₂O₃, TiN, AlN, ZrO₂, TiAlN, TiSiN, HfO, NbO₂, TaO₂, and MgF₂.

The first insulating layer 150A of the reflective structure 150 may be in contact with a side wall of each of the semiconductor light-emitting structure 110 and the transparent electrode layer 130. The first insulating layer 150A may include a material having strengthened total reflection characteristics. In some embodiments, the first insulating layer 150A may include an insulating material having a refractive index less than or equal to a refractive index of the semiconductor light-emitting structure 110 and/or the transparent electrode layer 130. For example, the first insulating layer 150A may include SiO₂ or MgF₂; however, embodiments are not limited thereto. Each of the first insulating layer 150A, the second insulating layer 150B, the third insulating layer 150C, and the fourth insulating layer 150D of the reflective structure 150 may have a thickness of about 10 nm to about 200 nm.

The reflective structure 150 may reflect light traveling from the inside of the semiconductor light-emitting structure 110 to the side wall to adjust the light distribution. As the reflective structure 150 includes a DBR, the reflective structure 150 may act as a band pass filter (BPF) suppressing the transmission of light of a particular wavelength, and a transmittance difference according to an incident angle may effectively adjust the light distribution. In addition, the reflective structure 150 may cause a relatively significant increase in the intensity of light emitted from a particular region by using the transmittance difference according to an incident angle of light emitted from the semiconductor light-emitting structure 110.

The light-emitting device 100 may include an insulating layer 160 covering the reflective structure 150. In some embodiments, the insulating layer 160 may include a silicon oxide, a silicon nitride, or a combination thereof. For example, the insulating layer 160 may include tetraethyl ortho silicate (TEOS), undoped silicate glass (USG), phosphosilicate glass (PSG), borosilicate glass (BSG), borophosphosilicate glass (BPSG), fluoride silicate glass (FSG), spin on glass SOG), polysilazane, or a combination thereof.

The reflective electrode layer 170 may partially cover the insulating layer 160 and may be in contact with the transparent electrode layer 130 by penetrating the reflective structure 150 in the first direction. The reflective electrode layer 170 may include portions in contact with the insulating layer 160 and portions in contact with the reflective structure 150.

According to the light-emitting device 100 described in relation to FIG. 1, by controlling the thickness 116T of the second conductivity type semiconductor layer 116 according to a wavelength of light emitted from the semiconductor light-emitting structure 110, the active layer 114 may be arranged at a position in the semiconductor light-emitting structure 110 to facilitate optimization of light extraction efficiency LEE of the light-emitting device 100, and accordingly, the light extraction efficiency of the light-emitting device 100 may be maximized. In addition, as the semiconductor light-emitting structure 110 constitutes a micro LED having a width of about 100 µm or less, in the semiconductor light-emitting structure 110, the active layer 114 may have a multi-quantum well structure for optimization of a micro-sized chip including the micro LED. Thus, according to some embodiments, the light-emitting device 100 having a structure better optimized to a micro-sized chip may be provided.

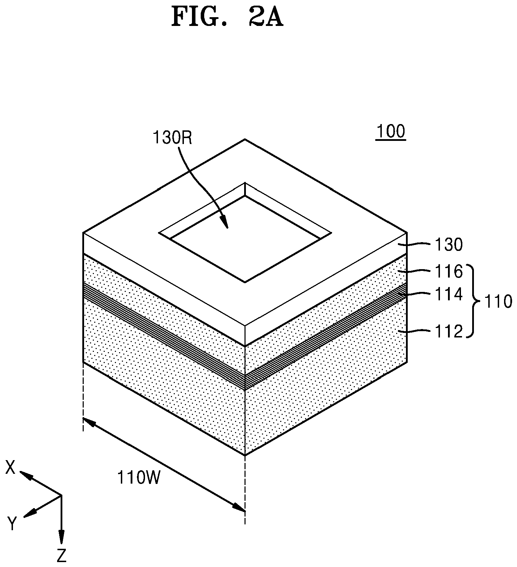

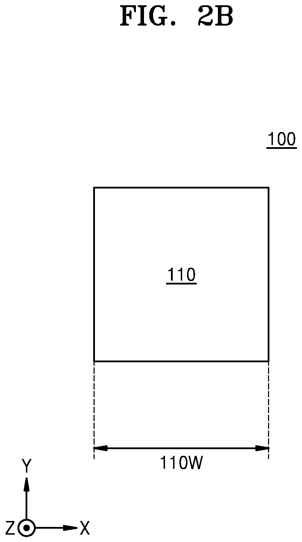

FIG. 2A is a schematic perspective view illustrating examples of shapes of the semiconductor light-emitting structure 110 and the transparent electrode layer 130, and FIG. 2B is a schematic plan view illustrating the semiconductor light-emitting structure 110.

Referring to FIGS. 2A and 2B, in a plan view (X-Y plane), each of the first conductivity type semiconductor layer 112, the active layer 114, and the second conductivity type semiconductor layer 116, which are included in the semiconductor light-emitting structure 110 and the transparent electrode layer 130 may have a tetragonal plane shape. A width 110W of the semiconductor light-emitting structure 110 in a horizontal direction (e.g., X direction or Y direction) parallel with the main surface 102M of the first conductivity type base semiconductor layer 102 (see FIG. 1) may be about 100 µm or less, about 50 µm or less, about 20 µm or less, about 10 µm or less, about 6 µm or less, about 5 µm or less, about 4 µm or less, or about 2 µm or less; however, embodiments are not limited thereto. In the horizontal direction (e.g., X direction or Y direction) parallel with the main surface 102M of the first conductivity type base semiconductor layer 102, the width of the transparent electrode layer 130 may be identical or similar to the width 110W of the semiconductor light-emitting structure 110.

In the transparent electrode layer 130, a local recess 130R may be formed in a surface opposite to a surface in contact with the semiconductor light-emitting structure 110. A part of the reflective electrode layer 170 illustrated in FIG. 1 may be accommodated in the local recess 130R of the transparent electrode layer 130.

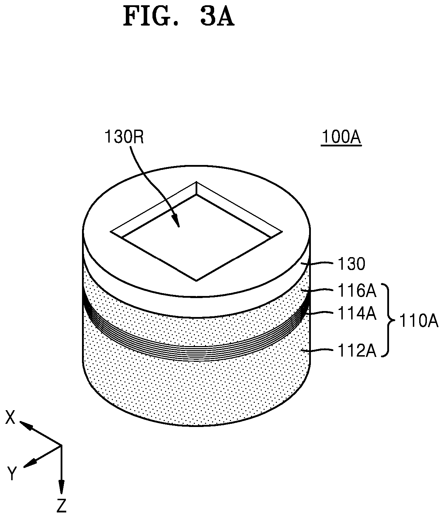

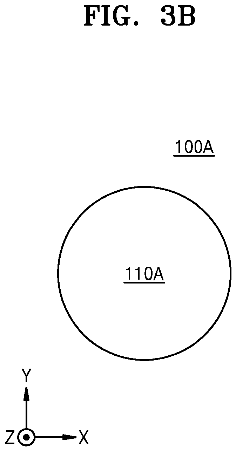

FIGS. 3A and 3B are diagrams illustrating a light-emitting device 100A according to some embodiments. FIG. 3A is a schematic perspective view illustrating an example of a shape of the transparent electrode layer 130 and a semiconductor light-emitting structure 110A included in the light-emitting device 100A, and FIG. 3B is a schematic plan view illustrating an example of a plane shape of the semiconductor light-emitting structure 110A. Like reference numerals in FIGS. 3A and 3B denote like members in FIG. 1, and thus any redundant description will be omitted.

Referring to FIGS. 3A and 3B, the light-emitting device 100A may have substantially the same configuration as the light-emitting device 100 described in relation to FIG. 1, but may include the semiconductor light-emitting structure 110A instead of the semiconductor light-emitting structure 110. The semiconductor light-emitting structure 110A may include a first conductivity type semiconductor layer 112A, an active layer 114A, and a second conductivity type semiconductor layer 116A.

The first conductivity type semiconductor layer 112A, the active layer 114A, and the second conductivity type semiconductor layer 116A may respectively have substantially the same configurations as the first conductivity type semiconductor layer 112, the active layer 114, and the second conductivity type semiconductor layer 116 described in relation to FIGS. 1, 2A, and 2B. In plan view (X-Y plane), the first conductivity type semiconductor layer 112A, the active layer 114A, and the second conductivity type semiconductor layer 116A which are included in the semiconductor light-emitting structure 110A may each have a circular plane shape.

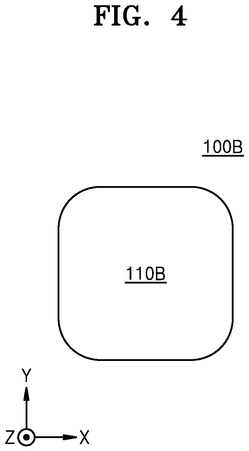

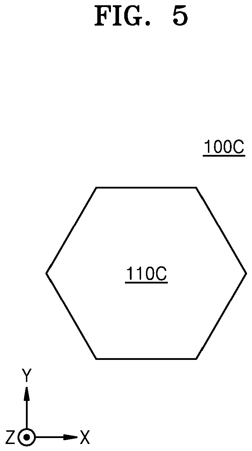

FIGS. 4 and 5 are plan views illustrating a light-emitting device (100B and 100C) according to some embodiments. FIG. 4 is a schematic plan view illustrating an example of a plane shape of a semiconductor light-emitting structure 110B included in the light-emitting device 100B, and FIG. 5 is a schematic plan view illustrating an example of a plane shape of a semiconductor light-emitting structure 110C included in the light-emitting device 100C.

Referring to FIG. 4, the light-emitting device 100B may have substantially the same configuration as the light-emitting device 100 described in relation to FIG. 1, but may include the semiconductor light-emitting structure 110B instead of the semiconductor light-emitting structure 110. The semiconductor light-emitting structure 110B may have substantially the same configuration as the semiconductor light-emitting structure 110 described in relation to FIG. 1. However, in plan view (X-Y plane), the semiconductor light-emitting structure 110B may have a tetragonal plane shape with round edges.

Referring to FIG. 5, the light-emitting device 100C may have substantially the same configuration as the light-emitting device 100 described in relation to FIG. 1, but may include the semiconductor light-emitting structure 110C instead of the semiconductor light-emitting structure 110. The semiconductor light-emitting structure 110C may have substantially the same configuration as the semiconductor light-emitting structure 110 described in relation to FIG. 1. However, in plan view (X-Y plane), the semiconductor light-emitting structure 110C may have a hexagonal plane shape.

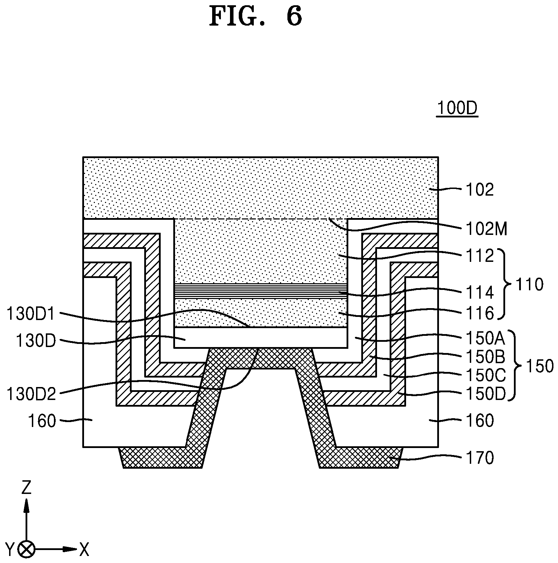

FIGS. 6, 7, and 8 are cross-sectional views illustrating light-emitting devices (100D, 100E, and 100F) according to some embodiments. Like reference numerals in FIGS. 6, 7, and 8 denote like members in FIG. 1, and thus any redundant description will be omitted.

Referring to FIG. 6, the light-emitting device 100D may have substantially the same configuration as the light-emitting device 100 described in relation to FIG. 1, but may include a transparent electrode layer 130D instead of the transparent electrode layer 130.

The transparent electrode layer 130D may have substantially the same configuration as the transparent electrode layer 130 described in relation to FIG. 1. In the transparent electrode layer 130D, a first surface 130D1 facing the second conductivity type semiconductor layer 116 and a second surface 130D2 facing the reflective electrode layer 170 may each extend flat in the horizontal direction (e.g., X direction and/or Y direction), and the entire transparent electrode layer 130D may have a generally consistent thickness in the first direction (Z direction in FIG. 6) (i.e., between the first surface 130D1 and the second surface 130D2). In some embodiments, in the first direction (Z direction in FIG. 6), the transparent electrode layer 130D may have a thickness of about 50 nm to about 150 nm, for example, a thickness of about 100 nm; however, embodiments are not limited thereto.

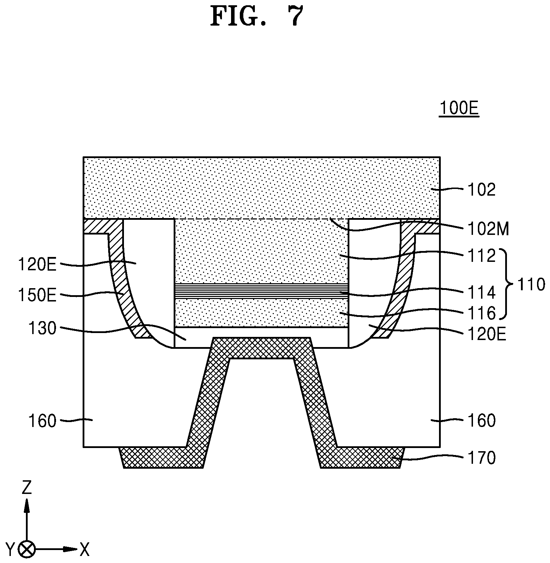

Referring to FIG. 7, the light-emitting device 100E may have substantially the same configuration as the light-emitting device 100 described in relation to FIG. 1, but may include an insulating spacer 120E and a reflective structure 150E instead of the reflective structure 150. The insulating spacer 120E and the reflective structure 150E may each cover a side wall of each of the first conductivity type semiconductor layer 112, the active layer 114, and the second conductivity type semiconductor layer 116 which are included in the semiconductor light-emitting structure 110 in the horizontal direction parallel with the main surface 102M of the first conductivity type base semiconductor layer 102.

The insulating spacer 120E may be in contact with the side wall of each of the first conductivity type semiconductor layer 112, the active layer 114, and the second conductivity type semiconductor layer 116 which are included in the semiconductor light-emitting structure 110, as well as the side wall of the transparent electrode layer 130. The reflective structure 150E may be spaced apart from each of the semiconductor light-emitting structure 110 and the transparent electrode layer 130 with the insulating spacer 120E arranged therebetween.

In some embodiments, the insulating spacer 120E may include SiO₂, SiON, TiO₂, Si₃N₄, Al₂O₃, TiN, AlN, ZrO₂, TiAlN, TiSiN, HfO, NbO₂, TaO₂, MgF₂, or a combination thereof. The reflective structure 150E may include a metal. For example, the reflective structure 150E may include silver (Ag), nickel (Ni), aluminum (Al), chrome (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof.

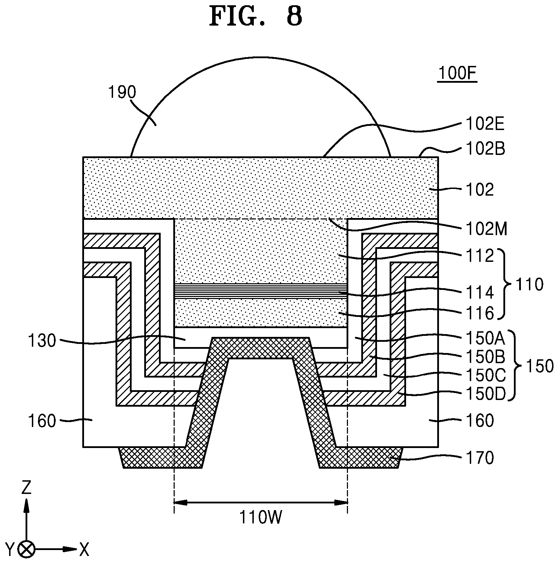

Referring to FIG. 8, the light-emitting device 100F may have substantially the same configuration as the light-emitting device 100 described in relation to FIG. 1, but may further include a microlens 190.

The microlens 190 may extract light emitted from the semiconductor light-emitting structure 110. The microlens 190 may be spaced apart from the first conductivity type semiconductor layer 112 in the first direction (Z direction in FIG. 7) with the first conductivity type base semiconductor layer 102 arranged therebetween. The main surface 102M of the first conductivity type base semiconductor layer 102 may be in contact with the first conductivity type semiconductor layer 112. The first conductivity type base semiconductor layer 102 may also include an emission surface 102E including a part of a rear surface 102B opposite to the main surface 102M. The microlens 190 may be arranged to overlap the semiconductor light-emitting structure 110 in the first direction. As the light-emitting device 100F further includes the microlens 190, the light extraction efficiency of the light-emitting device 100F may be further improved.

In some embodiments, the microlens 190 may include a spherical microlens or an aspherical microlens. In some embodiments, the microlens 190 may include a graded-refractive index layer formed in a multi-layer structure in which the refractive index gradually decreases in a light travel direction. The graded-refractive index layer may be formed by using an oblique deposition method, a sputtering method, an evaporation method, etc. The graded-refractive index layer may have a refractive index gradually decreasing in a direction towards a light output surface. In some embodiments, the microlens 190 may include TiO₂, SiC, GaN, GaP, SiN, SiON, ZrO₂, ITO, AlN, Al₂O₃, MgO, SiO₂, CaF₂, MgF₂, or a combination thereof; however, embodiments are not limited thereto.

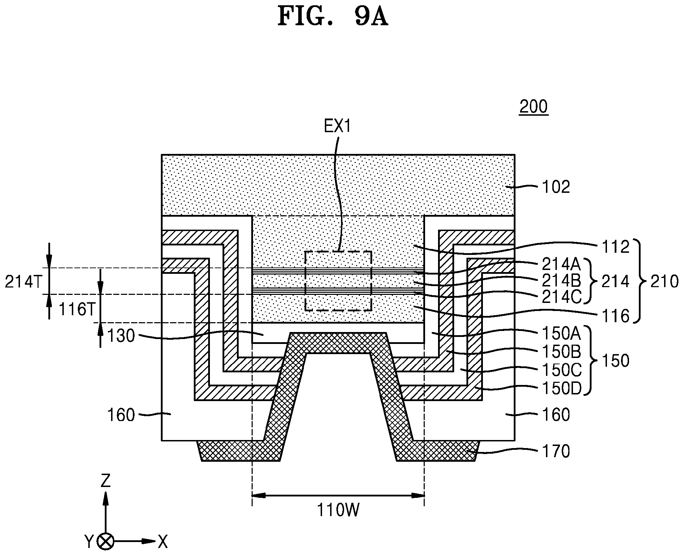

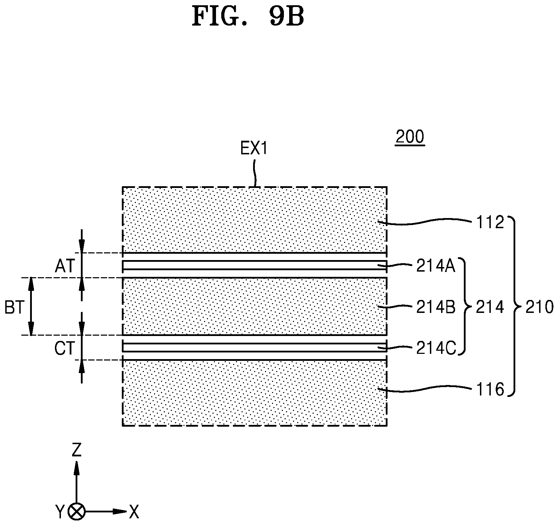

FIG. 9A is a cross-sectional view illustrating a light-emitting device 200 according to some embodiments. FIG. 9B is an enlarged cross-sectional view illustrating a part denoted by "EX1." Like reference numerals in FIGS. 9A and 9B denote like members in FIG. 1, and thus any redundant description will be omitted.

Referring to FIGS. 9A and 9B, the light-emitting device 200 may have substantially the same configuration as the light-emitting device 100 described in relation to FIG. 1, but may include a semiconductor light-emitting structure 210.

The semiconductor light-emitting structure 210 may have substantially the same configuration as the semiconductor light-emitting structure 110 described in relation to FIG. 1, but may include an active layer 214. The active layer 214 may include a first multi-quantum well layer 214A, a spacer barrier layer 214B, and a second multi-quantum well layer 214C, which are sequentially stacked on the first conductivity type semiconductor layer 112.

In the active layer 214, the first multi-quantum well layer 214A may include a surface in contact with the first conductivity type semiconductor layer 112, and the second multi-quantum well layer 214C may include a surface in contact with the second conductivity type semiconductor layer 116. The spacer barrier layer 214B may be arranged between the first multi-quantum well layer 214A and the second multi-quantum well layer 214C. The first multi-quantum well layer 214A and the second multi-quantum well layer 214C may be spaced apart from each other in the first direction (Z direction in FIGS. 9A and 9B) with the spacer barrier layer 214B arranged therebetween.

In the active layer 214, the first multi-quantum well layer 214A and the second multi-quantum well layer 214C may each have substantially the same configuration as the active layer 114 described in relation to FIG. 1. The first multi-quantum well layer 214A and the second multi-quantum well layer 214C may each have a thickness less than about 300 nm in the first direction. In the first direction, a thickness BT of the spacer barrier layer 214B may be greater than a thickness AT of the first multi-quantum well layer 214A and a thickness CT of the second multi-quantum well layer 214C.

In the active layer 214, at least one constituent material of the spacer barrier layer 214B may be identical to at least one constituent material selected in the first multi-quantum well layer 214A and the second multi-quantum well layer 214C. In some embodiments, the first multi-quantum well layer 214A and the second multi-quantum well layer 214C may each have a multi-quantum well structure in which a plurality of quantum barrier layers and a plurality of quantum well layers are alternately arranged. For example, in each of the first multi-quantum well layer 214A and the second multi-quantum well layer 214C, the quantum well layer may include an undoped InₓGa₁₋ₓN layer (0<x<1), and the quantum barrier layer may include an undoped GaN layer or a GaN layer doped with silicon (Si). In some embodiments, the spacer barrier layer 214B may include an InₓGa₁₋ₓN layer (0<x<1), an undoped GaN layer, or a GaN layer doped with silicon (Si).

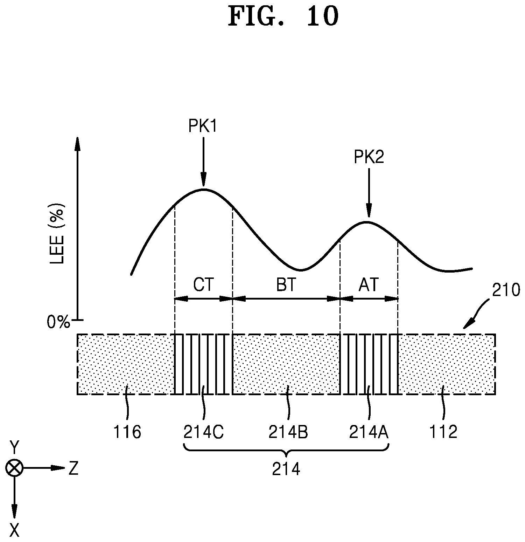

FIG. 10 is a diagram illustrating a relation between a change in the light extraction efficiency LEE according to a position of the active layer 214 of the semiconductor light-emitting structure 210 included in the light-emitting device 200 illustrated in FIGS. 9A and 9B and a position of each of the first multi-quantum well layer 214A and the second multi-quantum well layer 214C included in the active layer 214 of the semiconductor light-emitting structure 210.

Referring to FIG. 10, in the active layer 214, each of the second multi-quantum well layer 214C and the first multi-quantum well layer 214A may be arranged at a position corresponding to a peak (PK1 and PK2) of a value of the light extraction efficiency LEE of light passing through the active layer 214 of the semiconductor light-emitting structure 210. The second multi-quantum well layer 214C may extend from an interface between the second conductivity type semiconductor layer 116 and the second multi-quantum well layer 214C to a position passing the first peak PK1 of the value of the light extraction efficiency LEE in the first direction (Z direction). The first multi-quantum well layer 214A may extend from an interface between the spacer barrier layer 214B and the first multi-quantum well layer 214A to a position passing the second peak PK2 of the value of the light extraction efficiency LEE in the first direction (Z direction).

Each of the thickness AT of the first multi-quantum well layer 214A and the thickness CT of the second multi-quantum well layer 214C may be less than the thickness BT of the spacer barrier layer 214B, and the thickness BT of the spacer barrier layer 214B may be less than a distance between the two adjacent peaks (PK1 and PK2) of the value of the light extraction efficiency LEE of light passing through the active layer 214. Each of the thickness AT of the first multi-quantum well layer 214A and the thickness CT of the second multi-quantum well layer 214C may be less than 300 nm, less than 200 nm, less than 100 nm, less than 50 nm, less than 40 nm, less than 20 nm, less than 10 nm, less than 5 nm, or less than 3 nm. For example, the thickness 214T of the active layer 214 may be within a range from about 2 nm to about 10 nm; however, embodiments are not limited thereto. In some embodiments, each of the thickness AT of the first multi-quantum well layer 214A and the thickness CT of the second multi-quantum well layer 214C may be less than the thickness of a single multi-quantum well layer when the active layer 214 includes a single multi-quantum well layer.

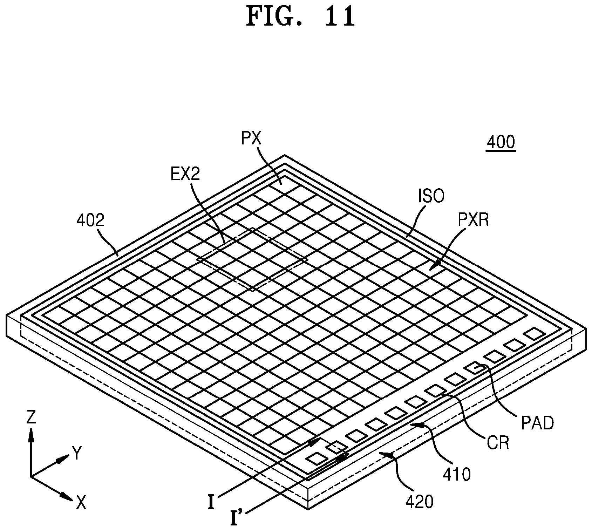

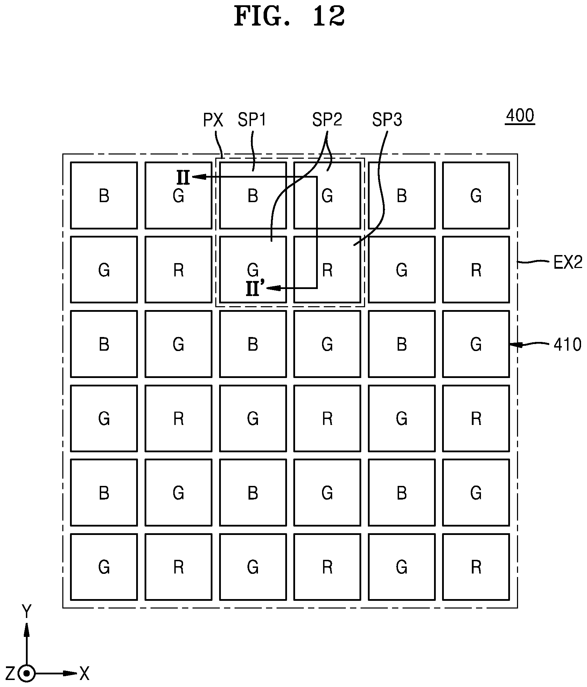

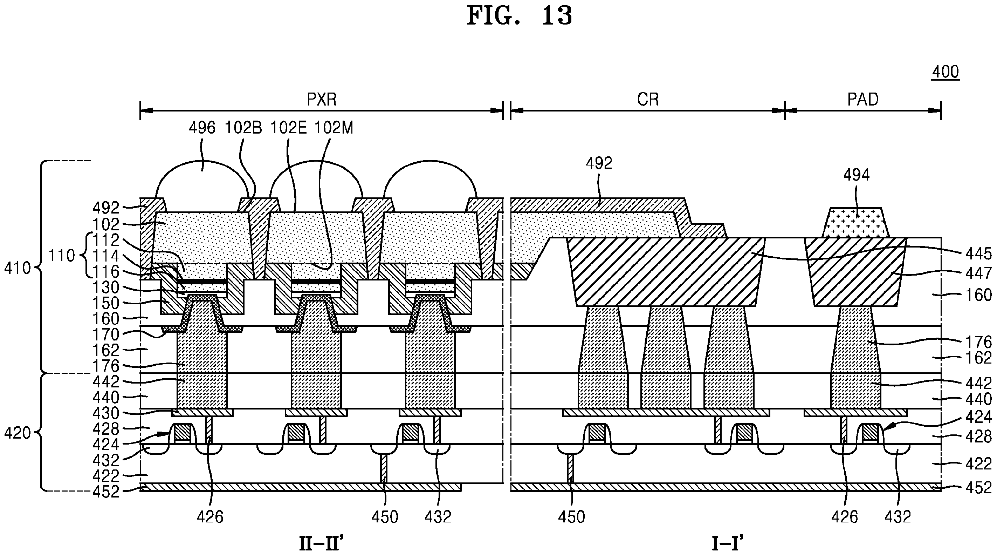

FIGS. 11 to 13 are diagrams illustrating a display device 400 according to some embodiments. FIG. 11 is a schematic perspective view of the display device 400, FIG. 12 is an enlarged plan view of a part denoted by "EX2" in FIG. 11, and FIG. 13 is a cross-sectional view schematically illustrating components of a portion along a cross-section cut by line I-I' in FIG. 11 and a portion along a cross-section cut by line II-II' in FIG. 12. Like reference numerals in FIGS. 11 to 13 denote like members in FIG. 1, and thus any redundant description will be omitted.

Referring to FIGS. 11 to 13, the display device 400 may include a pixel array 410 and a circuit board 420 which are arranged to overlap each other in the first direction (Z direction in FIG. 11). The circuit board 420 may include driver circuits. The pixel array 410 may include a plurality of pixels PX arranged in a pixel region PXR on the circuit board 420. The display device 400 may further include a frame 402 surrounding the pixel array 410 and the circuit board 420.

The circuit board 420 may be a driver circuit board including a plurality of transistors. In some embodiments, the circuit board 420 may include an application-specific integrated circuit (ASIC) including a plurality of driver circuits. In some embodiments, the circuit board 420 may include a flexible substrate. In this case, the display device 400 may be implemented as a variable or curved display device.

The pixel array 410 may include the pixel region PXR in which the plurality of pixels PX are arranged, a plurality of contact pad regions PAD in which a contact pad electrode 494 is arranged, a connection region CR for interconnecting the pixels PX to the contact pad electrode 494, and an edge region ISO.

The plurality of pixels PX may include a plurality of first subpixels SP1, a plurality of second subpixels SP2, and a plurality of third subpixels SP3, which are configured to emit light of a particular wavelength, for example, light of a particular color. The plurality of first subpixels SP1, the plurality of second subpixels SP2, and the plurality of third subpixels SP3 may each include a light-emitting device having the configuration described in relation to the semiconductor light-emitting structure 110 with reference to FIG. 1.

In some embodiments, the first to third subpixels SP1, SP2, and SP3 may respectively be configured to emit red (R) light, green (G) light, and blue (B) light. In some embodiments, each of the plurality of pixels PX may include the first to third subpixels SP1, SP2, and SP3 arranged in a Bayer pattern. That is, each of the plurality of pixels PX may include the first and third subpixels SP1 and SP3 arranged in a first diagonal direction and two second subpixels SP2 arranged in a second diagonal direction intersecting with the first diagonal direction. FIG. 12 illustrates that the first to third subpixels SP1, SP2, and SP3 are arranged in a 2X2 Bayer pattern in each of the plurality of pixels PX; however, embodiments are not limited thereto. For example, each of the plurality of pixels PX may have other arrangements, such as 3X3, 4X4, etc. In some embodiments, some of the plurality of pixels PX may be configured to emit light having a color other than red (R), green (G), and blue (B), for example, yellow light. FIG. 11 illustrates that in the pixel array 410, the plurality of pixels PX are in a 15X15 arrangement along a column direction and a row direction; however, embodiments are not limited thereto. The pixel array 410 may include a different number of pixels PX along a column direction and a row direction, for example, a plurality of pixels PX having a 1,024 X 768 arrangement.

The plurality of contact pad regions PAD may be arranged along an edge of the display device 400 on at least one side of the pixel region PXR. The plurality of contact pad regions PAD may be electrically connected to the plurality of pixels PX and the driver circuits of the circuit board 420. The display device 400 may be electrically connected to an external device through the plurality of contact pad regions PAD. The number of the contact pad regions PAD included in the display device 400 may vary. In some embodiments, the number of the plurality of contact pad regions PAD included in the display device 400 may be determined according to the number of the pixels PX included in the pixel array 410, a driving method of the driver circuit included in the circuit board 420, etc.

The connection region CR may be arranged between the pixel region PXR and the plurality of contact pad regions PAD. In the connection region CR, a wiring structure is electrically connected to the plurality of pixels PX, for example, a part of a grid electrode 492 and a common electrode 445 as illustrated in FIG. 13.

The edge region ISO of the display device 400 may be a region along edges of the pixel array 410. The semiconductor light-emitting structure 110 may not be arranged in the edge region ISO.

The frame 402 of the display device 400 may be arranged around the pixel array 410 and may serve as a guide defining a space in which the pixel array 410 is arranged. The frame 402 may include polymer, ceramic, semiconductor, metal, or a combination thereof.

As illustrated in FIG. 13, the circuit board 420 may include a semiconductor substrate 422, a driver circuit formed on the semiconductor substrate 422 and including a plurality of driver devices 424 including transistors, a plurality of interconnections 426 electrically connected to the plurality of driver devices 424, and a plurality of wiring lines 430 connected to the plurality of interconnections 426. The plurality of driver devices 424 constituting the driver circuit, the plurality of interconnections 426, and the plurality of wiring lines 430 may be covered by an insulating layer 428. The circuit board 420 may further include a first bonding insulating layer 440 on the insulating layer 428 and a plurality of first bonding electrodes 442 penetrating the first bonding insulating layer 440 and connected to the plurality of wiring lines 430.

The semiconductor substrate 422 may include a plurality of impurity regions 432 constituting source region/drain regions of the plurality of transistors constituting the plurality of driver devices 424. The semiconductor substrate 422 may include a semiconductor such as silicon (Si) or germanium (Ge) or a compound semiconductor such as SiGe, SiC, GaAs, InAs, or InP. The semiconductor substrate 422 may further include a plurality of through electrodes 450 connected to the driver circuit, such as a through silicon via (TSV) and a plurality of substrate wiring lines 452 connected to the plurality of through electrodes 450.

The driver circuit may be a circuit for controlling the drive of the pixels PX or the first to third subpixels SP1, SP2, and SP3. Some of the plurality of impurity regions 432 may be electrically connected to at least one of the first to third subpixels SP1, SP2, and SP3 through the interconnections 426, the wiring lines 430, and the first bonding electrodes 442. In some embodiments, some of the plurality of impurity regions 432 may be connected to one substrate wiring line 452 from among the plurality of substrate wiring lines 452 through the through electrode 450.

Upper surfaces of the plurality of first bonding electrodes 442 and an upper surface of the first bonding insulating layer 440 may constitute an upper surface of the circuit board 420. The plurality of first bonding electrodes 442 included in the circuit board 420 may be bonded to a plurality of second bonding electrodes 176 included in the pixel array 410 and provide an electrical connection path. In some embodiments, the plurality of first bonding electrodes 442 and the plurality of second bonding electrodes 176 may each include a copper (Cu) film. Each of the plurality of first bonding electrodes 442 and the plurality of second bonding electrodes 176 may further include a barrier metal layer surrounding the copper (Cu) film. The barrier metal layer may include Ta, TaN, or a combination thereof.

The first bonding insulating layer 440 included in the circuit board 420 may be bonded to a second bonding insulating layer 162 included in the pixel array 410. Each of the first bonding insulating layer 440 and the second bonding insulating layer 162 may include SiO, SiN, SiCN, SiOC, SiON, SiOCN, or a combination thereof.

In the pixel array 410, each of the first to third subpixels SP1, SP2, and SP3 may include the semiconductor light-emitting structure 110 described in relation to FIG. 1. More specifically, the pixel array 410 may include the first conductivity type base semiconductor layer 102 including a main surface 102M and the rear surface 102B which face each other and the plurality of semiconductor light-emitting structures 110 arranged on the main surface 102M of the first conductivity type base semiconductor layer 102. The plurality of semiconductor light-emitting structures 110 may be spaced apart from each other in the horizontal direction parallel with the main surface 102M of the first conductivity type base semiconductor layer 102. Each of the plurality of semiconductor light-emitting structures 110 may include the first conductivity type semiconductor layer 112, the active layer 114, and the second conductivity type semiconductor layer 116 which are sequentially stacked in the first direction perpendicular to the main surface 102M of the first conductivity type base semiconductor layer 102. Detailed configurations of the first conductivity type semiconductor layer 112, the active layer 114, and the second conductivity type semiconductor layer 116 are each the same as described above in relation to FIG. 1.

The pixel array 410 may further include the grid electrode 492 penetrating the first conductivity type base semiconductor layer 102 in the first direction. The grid electrode 492 may include a metal layer having a grid shape. The grid electrode 492 may be referred to as a first electrode. The grid electrode 492 may include local regions extending along regions between the plurality of semiconductor light-emitting structures 110 in a plan view parallel with the main surface 102M of the first conductivity type base semiconductor layer 102, and the local regions of the grid electrode 492 may be connected to each other to form a single layer and may be arranged to surround each of the plurality of semiconductor light-emitting structures 110. The local regions of the grid electrode 492 may be connected to each other to form a grid shape or a mesh shape. As such, as the grid electrode 492 is arranged to fill the spaces between the plurality of semiconductor light-emitting structures 110, the spreading of current may be improved, and the light emission efficiency at the pixel array 410 of the display device 400 may increase. In some embodiments, by forming the grid electrode 492 through a plating process, the relatively narrow spaces between the plurality of semiconductor light-emitting structures 110 may be stably filled.

A part of the grid electrode 492 may be in contact with a side wall of the first conductivity type base semiconductor layer 102. Another part of the grid electrode 492 may be in contact with the rear surface 102B of the first conductivity type base semiconductor layer 102 to define the emission surface 102E including a part of the rear surface 102B of the first conductivity type base semiconductor layer 102. In some embodiments, the grid electrode 492 may include silver (Ag), nickel (Ni), aluminum (Al), chrome (Cr), rhodium (Rh), iridium (Ir), palladium (Pd), ruthenium (Ru), magnesium (Mg), zinc (Zn), platinum (Pt), gold (Au), or a combination thereof.

A plurality of microlenses 496 may be arranged on the emission surface 102E defined by the grid electrode 492, of the rear surface 102B of the first conductivity type base semiconductor layer 102. Each of the plurality of microlenses 496 may be in contact with a portion covering the rear surface 102B, of the grid electrode 492. The plurality of microlenses 496 may be arranged to overlap the plurality of semiconductor light-emitting structures 110 in the direction perpendicular to the main surface 102M of the first conductivity type base semiconductor layer 102. Detailed configuration of the plurality of microlenses 496 is substantially the same as the configuration of the microlens 190 described in relation to FIG. 8.

The pixel array 410 of the display device 400 may further include the transparent electrode layer 130, the reflective structure 150, and the reflective electrode layer 170 penetrating the reflective structure 150 and in contact with the transparent electrode layer 130. Detailed configurations of the transparent electrode layer 130, the reflective structure 150, and the reflective electrode layer 170 are the same as described in relation to FIG. 1.

The plurality of semiconductor light-emitting structures 110 included in the pixel array 410 of the display device 400 may be configured to emit light having a wavelength (λ) within a range from about 400 nm to about 700 nm, for example, a wavelength (λ) within a range from about 490 nm to about 700 nm. A minimum distance from the transparent electrode layer 130 to the active layer 114 in the direction perpendicular to the main surface 102M of the first conductivity type base semiconductor layer 102 may be determined according to wavelength (λ) of light emitted from the semiconductor light-emitting structure 110. A minimum distance from the reflective electrode layer 170 to the active layer 114 in the direction perpendicular to the main surface 102M of the first conductivity type base semiconductor layer 102 may be greater than 0.05λ and less than 0.4λ. In some embodiments, the minimum distance from the reflective electrode layer 170 to the active layer 114 in the direction perpendicular to the main surface 102M of the first conductivity type base semiconductor layer 102 may be greater than 0.05λ and less than 0.24λ.

In the pixel array 410 of the display device 400, the plurality of second bonding electrodes 176 may be connected to the plurality of reflective electrode layers 170, the second bonding insulating layer 162 surrounding the plurality of second bonding electrodes 176 may be in contact with a part of the reflective electrode layer 170 and may be in contact with the insulating layer 160 covering the reflective structure 150.

The display device 400 may further include a common electrode 445 and an inner pad electrode 447. In the pixel array 410, the insulating layer 160 covering the reflective electrode layer 170 may extend to the connection region CR and the contact pad regions PAD to cover the common electrode 445 and the inner pad electrode 447.

The grid electrode 492 may extend from the pixel region PXR to the connection region CR and may be physically in contact with the first conductivity type base semiconductor layer 102 and the common electrode 445 in the connection region CR. The grid electrode 492 may be electrically connected to the first conductivity type base semiconductor layer 102 and the common electrode 445. In the contact pad regions PAD, the contact pad electrode 494 may be arranged on the inner pad electrode 447.

The plurality of second bonding electrodes 176 may be connected to the common electrode 445. The common electrode 445 may have a ring shape or a tetragonal ring shape surrounding a pixel region PXA in a plan view parallel with the main surface 102M of the first conductivity type base semiconductor layer 102. However, the arrangement of the common electrode 445 may be variously modified or changed according to a need.

In the contact pad regions PAD, the contact pad electrode 494 may be arranged on the inner pad electrode 447. The inner pad electrode 447 may be in contact with the contact pad electrode 494. The inner pad electrode 447 may be arranged between the contact pad electrode 494 and the second bonding electrodes 176 and interconnect the contact pad electrode 494 and the second bonding electrodes 176 to each other. The common electrode 445 and the inner pad electrode 447 may include a conductive material, for example, silver (Ag), nickel (Ni), aluminum (Al), chrome (Cr), rhodium (Rh), iridium (Ir), palladium (Pd), ruthenium (Ru), magnesium (Mg), zinc (Zn), platinum (Pt), gold (Au), or a combination thereof.

The contact pad electrode 494 may be connected to an external device or an external integrated circuit (IC) which may apply an electric signal to the circuit board 420 through wire bonding or anisotropic conductive film (AFC) bonding. The contact pad electrode 494 may electrically connect the external device to the driver circuits of the circuit board 420. The contact pad electrode 494 may include a metal, for example, gold (Au), silver (Ag), nickel (Ni), etc.

From among the plurality of second bonding electrodes 176, the second bonding electrode(s) 176 arranged in the pixel region PXR may be connected to the reflective electrode layer 170, from among the plurality of second bonding electrodes 176, the second bonding electrode(s) 176 arranged in the connection region CR may be connected to the common electrode 445, and from among the second bonding electrodes 176, the second bonding electrode(s) 176 arranged in the contact pad region PAD may be connected to the inner pad electrode 447. The grid electrode 492 may be connected to the plurality of second bonding electrodes 176 through the common electrode 445.

A surface of the second bonding insulating layer 162 which faces the circuit board 420 and surfaces of the plurality of second bonding electrodes 176 which face the circuit board 420 may extend on one plane. The second bonding insulating layer 162 may form a dielectric-dielectric bonding along with the first bonding insulating layer 440. The circuit board 420 and the pixel array 410 may be bonded to each other by the bonding between the plurality of first bonding electrodes 442 and the plurality of second bonding electrodes 176 and the bonding between the first bonding insulating layer 440 and the second bonding insulating layer 162.

In some embodiments, the bonding between the plurality of first bonding electrodes 442 and the plurality of second bonding electrodes 176 may be, for example, copper (Cu)-copper (Cu) bonding, and the bonding between the first bonding insulating layer 440 and the second bonding insulating layer 162 may be dielectric-dielectric bonding such as SiCN-SiCN bonding. The circuit board 420 and the pixel array 410 may be bonded by hybrid bonding including copper (Cu)-copper (Cu) bonding and dielectric-dielectric bonding or may be bonded without a separate bonding layer.

The display device 400 may include the plurality of semiconductor light-emitting structures 110, and by controlling the thickness 116T of the second conductivity type semiconductor layer 116 according to a wavelength of light emitted from the plurality of semiconductor light-emitting structures 110, the active layer 114 may be arranged in a position facilitating the optimization of light extraction efficiency LEE of the light-emitting device 100 in each of the plurality of semiconductor light-emitting structures 110. Accordingly, the light extraction efficiency may be maximized in the pixel region PXA of the display device 400. In addition, in the pixel region PXA of the display device 400, the semiconductor light-emitting structure 110 may constitute a micro LED having a width of about 100 µm or less, and in the semiconductor light-emitting structure 110, the active layer 114 may have a multi-quantum well structure optimized to a micro-sized chip including the micro LED. Accordingly, the display device 400 having a structure optimized to a micro-sized chip may be provided.

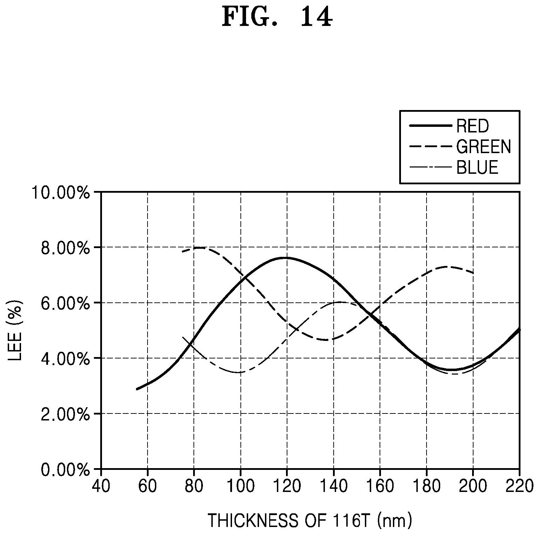

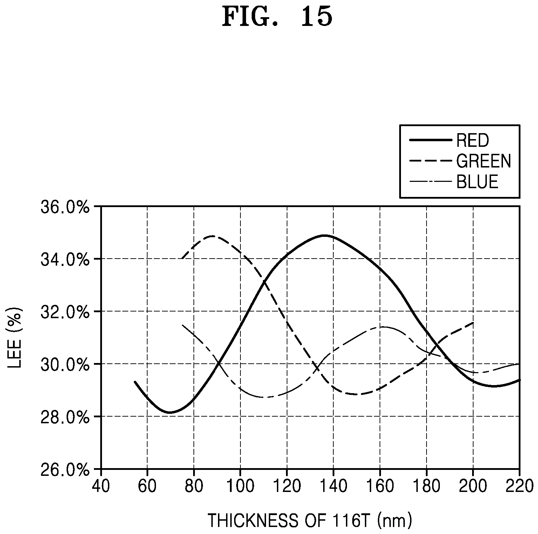

FIGS. 14 and 15 are graphs showing simulation results for evaluation of the light extraction efficiency LEE of a light-emitting device according to some embodiments.

For evaluation of FIG. 14, the light extraction efficiency LEE according to the thickness 116T of the second conductivity type semiconductor layer 116 was evaluated for each of red light having a wavelength (λ) of 630 nm, green light having a wavelength (λ) of 530 nm, and blue light having a wavelength (λ) of 460 nm in the light-emitting device including the semiconductor light-emitting structure 110 having the configuration described in relation to FIG. 1. In FIG. 14, the vertical axis represents the light extraction efficiency LEE within an emission angle range of ±10 degrees.

From the evaluation result of FIG. 14, a range of the thickness 116T of the second conductivity type semiconductor layer 116 may be determined based on a position where a peak value from among the values of light extraction efficiency LEE is present in each of red light, green light, and blue light.

In some embodiments, based on the result of FIG. 14, for the red light having a wavelength (λ) of 630 nm, the thickness 116T of the second conductivity type semiconductor layer 116 may be set to be greater than 0.05λ and less than 0.3λ. For example, when the thickness 116T of the second conductivity type semiconductor layer 116 is set to be greater than 0.15λ and less than 0.21λ, the thickness 116T of the second conductivity type semiconductor layer 116 may be within a range from about 95 nm to about 135 nm.

In some embodiments, based on the result of FIG. 14, for the green light having a wavelength (λ) of 530 nm, the thickness 116T of the second conductivity type semiconductor layer 116 may be set to be greater than 0.05λ and less than 0.3λ. For example, when the thickness 116T of the second conductivity type semiconductor layer 116 is set to be greater than 0.11λ and less than 0.19λ, the thickness 116T of the second conductivity type semiconductor layer 116 may be within a range from about 60 nm to about 100 nm.

In some embodiments, based on the result of FIG. 14, for the blue light having a wavelength (λ) of 460 nm, the thickness 116T of the second conductivity type semiconductor layer 116 may be set to be greater than 0.05λ and less than 0.4λ. For example, when the thickness 116T of the second conductivity type semiconductor layer 116 is set to be greater than 0.27λ and less than 0.36λ, the thickness 116T of the second conductivity type semiconductor layer 116 may be within a range from about 125 nm to about 165 nm.

For the evaluation of FIG. 15, a method substantially the same as the evaluation method of FIG. 14 was used, but the vertical axis in FIG. 15 represents the light extraction efficiency LEE without limiting an emission angle to a particular range.

From the evaluation result of FIG. 15, a range of the thickness 116T of the second conductivity type semiconductor layer 116 may be determined based on a position where a peak value from among the values of light extraction efficiency LEE is present in each of red light, green light, and blue light.

In some embodiments, based on the result of FIG. 15, for the red light having a wavelength (λ) of 630 nm, the thickness 116T of the second conductivity type semiconductor layer 116 may be set to be greater than 0.05λ and less than 0.3λ. For example, when the thickness 116T of the second conductivity type semiconductor layer 116 is set to be greater than 0.18λ and less than 0.25λ, the thickness 116T of the second conductivity type semiconductor layer 116 may be within a range from about 115 nm to about 155 nm.

In some embodiments, based on the result of FIG. 15, for the green light having a wavelength (λ) of 530 nm, the thickness 116T of the second conductivity type semiconductor layer 116 may be set to be greater than 0.05λ and less than 0.3λ. For example, when the thickness 116T of the second conductivity type semiconductor layer 116 is set to be greater than 0.12λ and less than 0.2λ, the thickness 116T of the second conductivity type semiconductor layer 116 may be within a range from about 65 nm to about 105 nm.

In some embodiments, based on the result of FIG. 15, for the blue light having a wavelength (λ) of 460 nm, the thickness 116T of the second conductivity type semiconductor layer 116 may be set to be greater than 0.05λ and less than 0.4λ. For example, when the thickness 116T of the second conductivity type semiconductor layer 116 is set to be greater than 0.30λ and less than 0.39λ, the thickness 116T of the second conductivity type semiconductor layer 116 may be within a range from about 140 nm to about 180 nm.

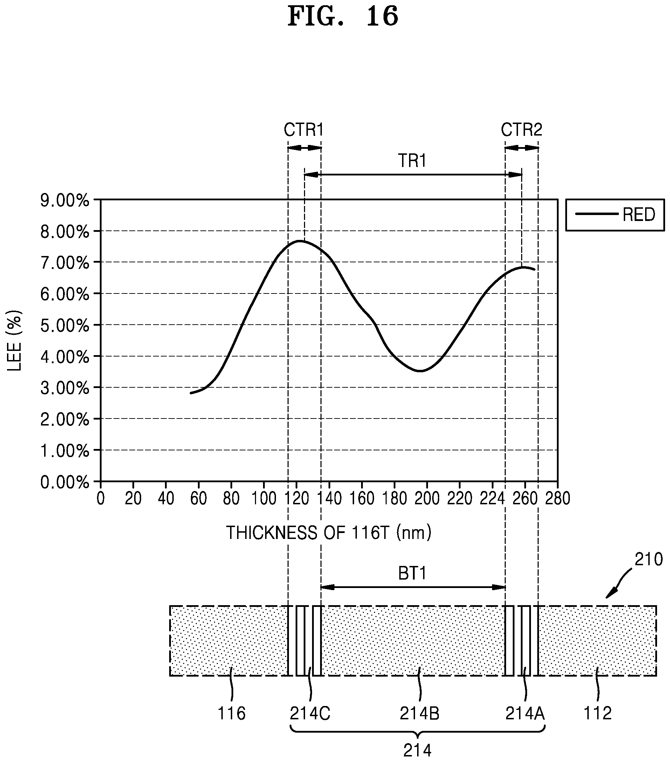

FIGS. 16, 17, and 18 illustrate graphs showing simulation results for evaluation of light extraction efficiency LEE of a light-emitting device according to some embodiments.

For evaluation of FIGS. 16, 17, and 18, the light extraction efficiency LEE according to the thickness 116T of the second conductivity type semiconductor layer 116 was evaluated for each of red light having a wavelength (λ) of 630 nm, green light having a wavelength (λ) of 530 nm, and blue light having a wavelength (λ) of 460 nm in the light-emitting device including the semiconductor light-emitting structure 210 having the configuration described in relation to FIGS. 9A and 9B. In FIGS. 16, 17, and 18, the vertical axis represents the light extraction efficiency LEE within an emission angle range of ±10 degrees.

From the evaluation results of FIGS. 16, 17, and 18, a range of the thickness 116T of the second conductivity type semiconductor layer 116 may be determined based on a position where a peak value from among the values of light extraction efficiency LEE is present in each of red light, green light, and blue light, according to a method similar to the method described in relation to FIG. 14. In addition, based on the evaluation results of FIGS. 16, 17, and 18, the second multi-quantum well layer 214C and the first multi-quantum well layer 214A in the active layer 214 may respectively be designed to be located at positions corresponding to the first peak and the second peak of the light extraction efficiency LEE value of light passing through the active layer 214 of the semiconductor light-emitting structure 210.

For example, as for red light, the size of the active layer 214 may be designed based on the evaluation result of FIG. 16. That is, a thickness CTR1 of the second multi-quantum well layer 214C may be designed to extend from the interface between the second conductivity type semiconductor layer 116 and the second multi-quantum well layer 214C to a position passing the first peak of the value of the light extraction efficiency LEE towards the first conductivity type semiconductor layer 112. A thickness CTR2 of the first multi-quantum well layer 214A may be designed to extend from the interface between the spacer barrier layer 214B and the first multi-quantum well layer 214A to a position passing the second peak of the value of the light extraction efficiency LEE towards the first conductivity type semiconductor layer 112. A thickness BT1 of the spacer barrier layer 214B may be designed to be greater than the thickness CTR2 of the first multi-quantum well layer 214A, greater than the thickness CTR1 of the second multi-quantum well layer 214C, and less than a distance TR1 between a position where the first peak of the light extraction efficiency LEE value is present and a position where the second peak of the light extraction efficiency LEE value is present.

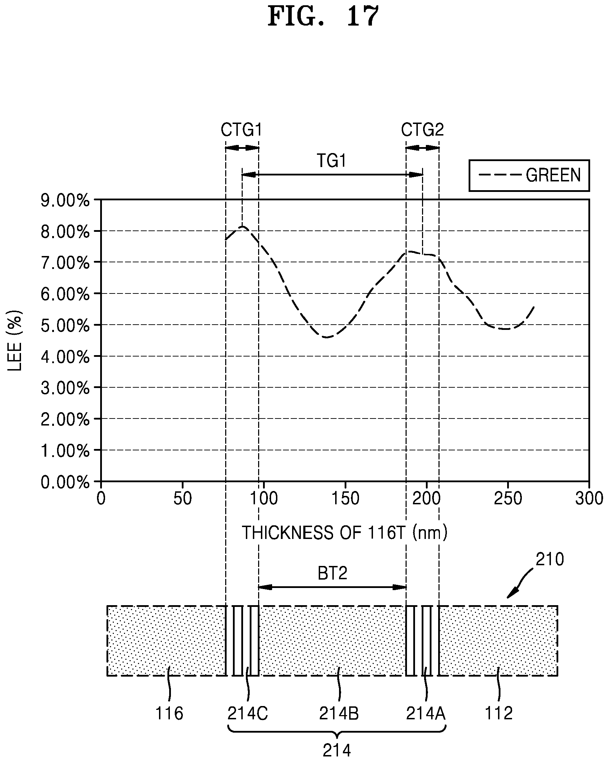

As for green light, the size of the active layer 214 may be designed based on the evaluation result of FIG. 17. That is, a thickness CTG1 of the second multi-quantum well layer 214C may be designed to extend from the interface between the second conductivity type semiconductor layer 116 and the second multi-quantum well layer 214C to a position passing the first peak of the value of the light extraction efficiency LEE towards the first conductivity type semiconductor layer 112. A thickness CTG2 of the first multi-quantum well layer 214A may be designed to extend from the interface between the spacer barrier layer 214B and the first multi-quantum well layer 214A to a position passing the second peak of the value of the light extraction efficiency LEE towards the first conductivity type semiconductor layer 112. A thickness BT2 of the spacer barrier layer 214B may be designed to be greater than the thickness CTG2 of the first multi-quantum well layer 214A, greater than the thickness CTG1 of the second multi-quantum well layer 214C, and less than a distance TG1 between a position where the first peak of the light extraction efficiency LEE value is present and a position where the second peak of the light extraction efficiency LEE value is present.

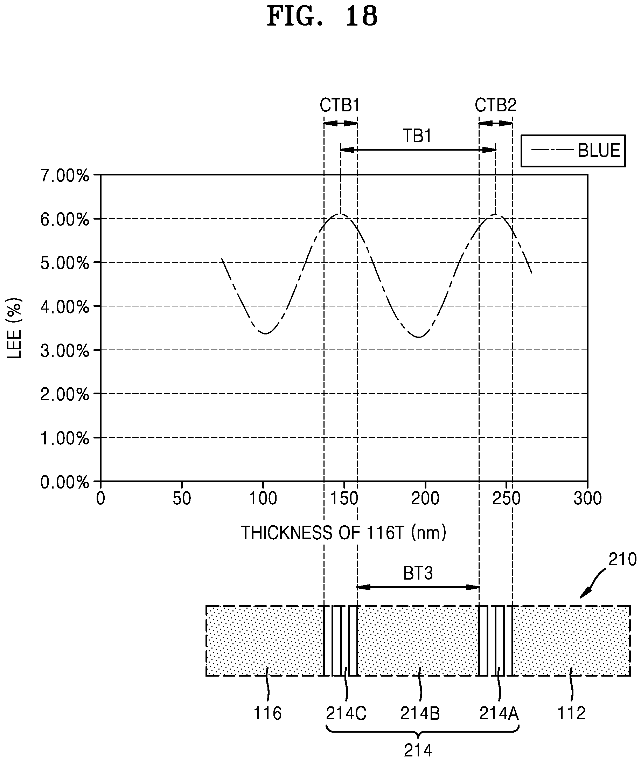

As for blue light, the size of the active layer 214 may be designed based on the evaluation result of FIG. 18. That is, a thickness CTB1 of the second multi-quantum well layer 214C may be designed to extend from the interface between the second conductivity type semiconductor layer 116 and the second multi-quantum well layer 214C to a position passing the first peak of the value of the light extraction efficiency LEE towards the first conductivity type semiconductor layer 112. A thickness CTB2 of the first multi-quantum well layer 214A may be designed to extend from the interface between the spacer barrier layer 214B and the first multi-quantum well layer 214A to a position passing the second peak of the value of the light extraction efficiency LEE towards the first conductivity type semiconductor layer 112. A thickness BT3 of the spacer barrier layer 214B may be designed to be greater than the thickness CTB2 of the first multi-quantum well layer 214A, greater than the thickness CTB1 of the second multi-quantum well layer 214C, and less than a distance TB1 between a position where the first peak of the light extraction efficiency LEE value is present and a position where the second peak of the light extraction efficiency LEE value is present.

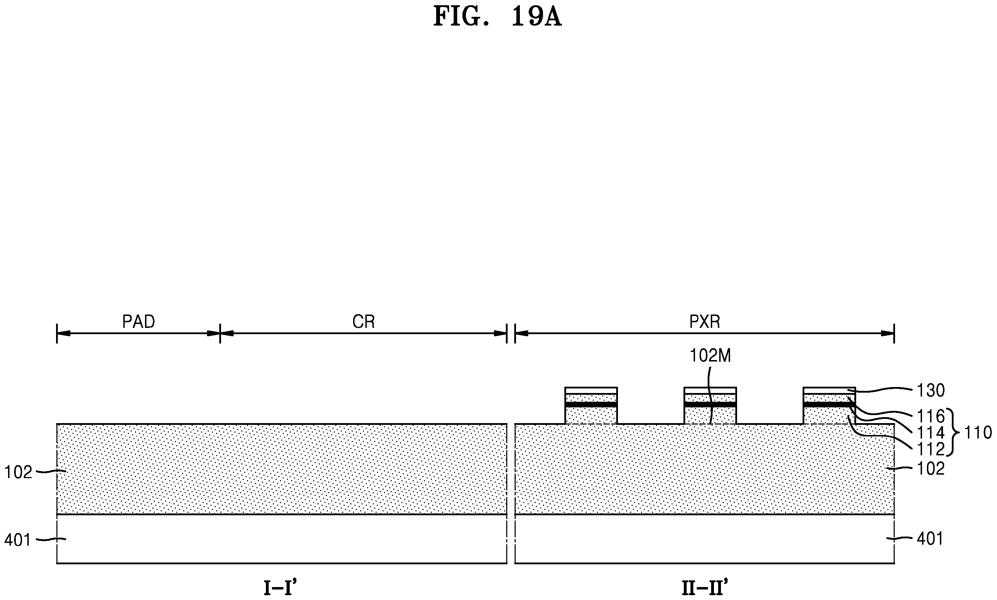

FIGS. 19A to 19G each illustrate a cross-sectional view illustrating a method of manufacturing a display device including a light-emitting device according to a process order, according to some embodiments. Referring to FIGS. 19A to 19G, an example of a method of manufacturing the display device 400 described in relation to FIGS. 11, 12, and 13 is described. Like reference numerals in FIGS. 19A to 19G denote like members in FIGS. 1 to 13, and thus any redundant description will be omitted.

Referring to FIG. 19A, by using a semiconductor single crystal growth process, a deposition process, an etching process, etc. using a substrate for growth 401, a structure in which the first conductivity type base semiconductor layer 102, the plurality of semiconductor light-emitting structures 110 arranged in the pixel region PXR and each including the first conductivity type semiconductor layer 112, the active layer 114, and the second conductivity type semiconductor layer 116, and the plurality of transparent electrode layers 130 covering the plurality of semiconductor light-emitting structures 110 are arranged may be formed on the substrate for growth 401.

The substrate for growth 401 may be a substrate for semiconductor single crystal growth and may include AlN, AlGaN, ZnO, GaAs, MgAl₂O₄, MgO, LiAlO₂, LiGaO₂, GaN, or a combination thereof. In some embodiments, for improvement in crystallinity of semiconductor layers and light extraction efficiency, at least a part of an upper surface of the substrate for growth 401 may have an uneven structure. In this case, layers grown on the substrate for growth 401 may also have an uneven structure.

In some embodiments, to form the structure illustrated in FIG. 19A, the first conductivity type base semiconductor layer 102, the first conductivity type semiconductor layer 112, the active layer 114, and the second conductivity type semiconductor layer 116 may be sequentially formed on the substrate for growth 401, and the transparent electrode layer 130 may be formed on the second conductivity type semiconductor layer 116. By an etching process using a hard mask pattern as an etching mask, each of the transparent electrode layer 130, the second conductivity type semiconductor layer 116, the active layer 114, and the first conductivity type semiconductor layer 112 may be partially etched such that the plurality of semiconductor light-emitting structures 110 and the plurality of transparent electrode layers 130 covering the plurality of semiconductor light-emitting structures 110 which are spaced apart from each other are left on the first conductivity type base semiconductor layer 102. The plurality of semiconductor light-emitting structures 110 may form a plurality of cylindrical shapes having a circular, elliptical, or polygonal plane shape, along with the plurality of transparent electrode layers 130.

The first conductivity type base semiconductor layer 102, the first conductivity type semiconductor layer 112, the active layer 114, and the second conductivity type semiconductor layer 116 may be formed by using a metal organic chemical vapor deposition (MOCVD) process, a hydride vapor phase epitaxy (HVPE) process, or a molecular beam epitaxy (MBE) process. The constituent materials and thicknesses of the first conductivity type base semiconductor layer 102, the first conductivity type semiconductor layer 112, the active layer 114, and the second conductivity type semiconductor layer 116 may be the same as described in relation to FIG. 1. For example, the second conductivity type semiconductor layer 116 in different semiconductor light-emitting structures 110 may have different thicknesses.

In some embodiments, in each of the plurality of semiconductor light-emitting structures 110, a wet etching process may be further performed to remove damaged regions due to the etching. In the wet etching process, by controlling process conditions to differentiate the selectivity of crystal surfaces, the damaged portions may be selectively removed from each of the plurality of semiconductor light-emitting structure 110, and the side wall of each of the plurality of semiconductor light-emitting structures 110 may have a profile extending in a direction perpendicular to the main surface 102M of the first conductivity type base semiconductor layer 102. In addition, the non-radiative recombination due to the damaged regions may decrease in the side wall of each of the plurality of semiconductor light-emitting structures 110, which may lead to improved luminance in a light-emitting device.

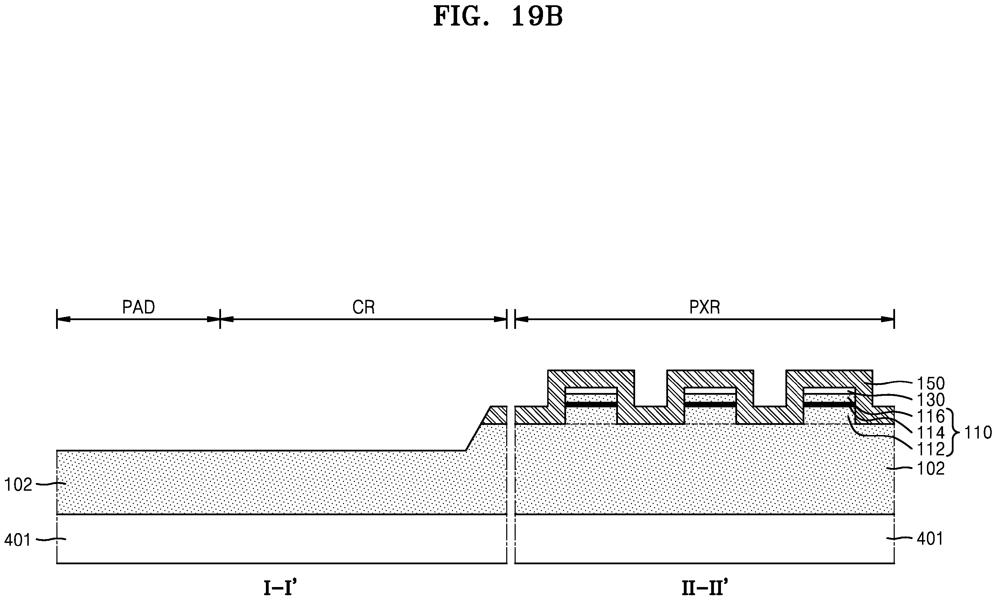

Referring to FIG. 19B, from the resulting product of FIG. 19A, the reflective structure 150 covering surfaces of the first conductivity type base semiconductor layer 102, the plurality of semiconductor light-emitting structures 110, and the plurality of transparent electrode layers 130 may be formed, and the reflective structure 150 may be partially removed in the connection region CR and the contact pad region PAD to expose the first conductivity type base semiconductor layer 102. By partially removing the exposed first conductivity type base semiconductor layer 102 by a certain thickness, the thickness of the first conductivity type base semiconductor layer 102 may be reduced in the connection region CR and the contact pad region PAD.

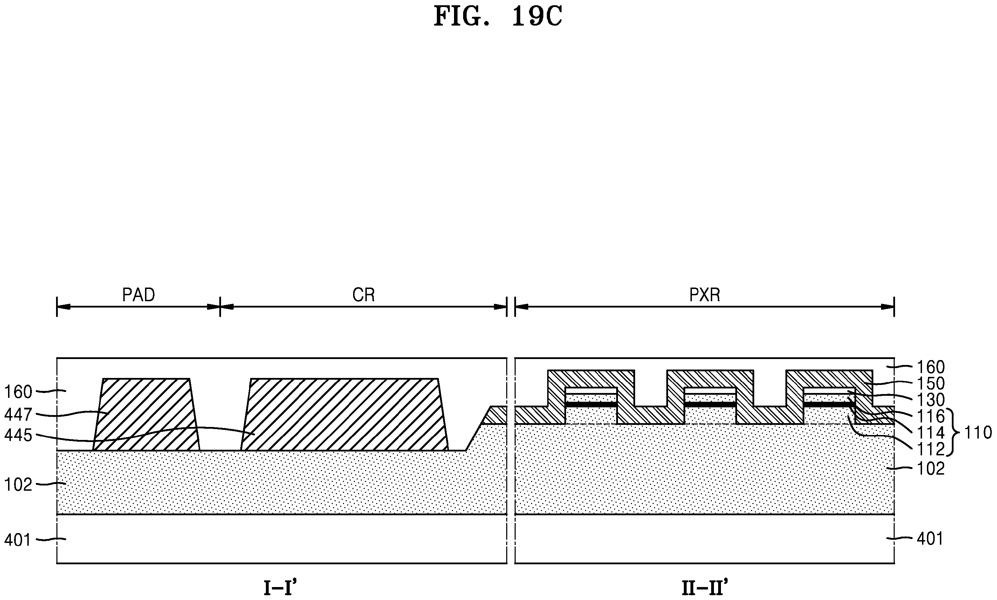

Referring to FIG. 19C, the common electrode 445 arranged on the first conductivity type base semiconductor layer 102 may be formed in the connection region CR, and the inner pad electrode 447 arranged on the first conductivity type base semiconductor layer 102 may be formed in the contact pad region PAD. The insulating layer 160 covering a resulting product may be formed. The insulating layer 160 may be formed to cover the reflective structure 150 in the pixel region PXR and to cover the common electrode 445 and the inner pad electrode 447 in the connection region CR and the contact pad region PAD. The insulating layer 160 may be formed to have a flat upper surface.

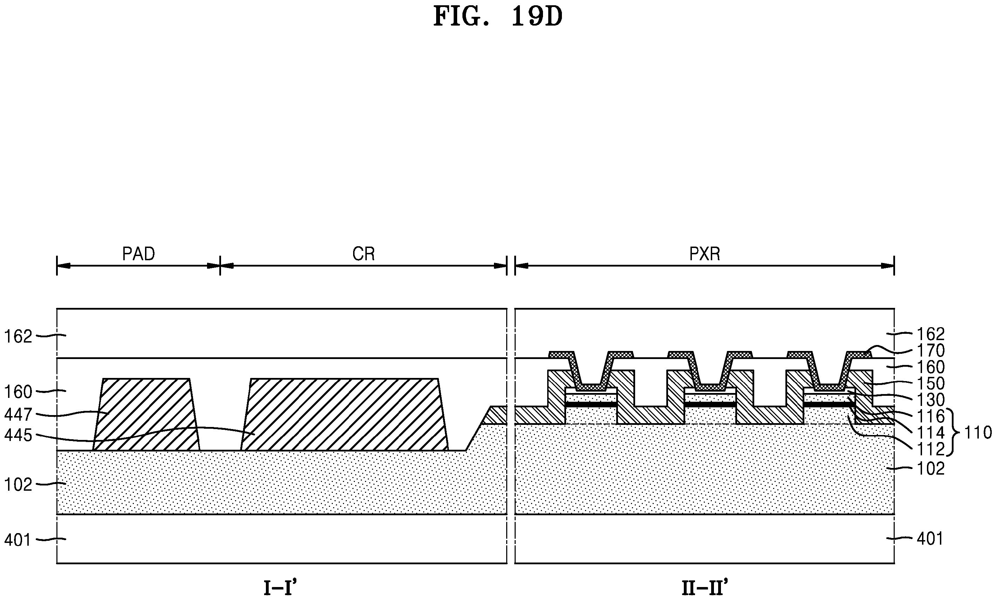

Referring to FIG. 19D, from the resulting product of FIG. 19C, parts of the insulating layer 160 and the reflective structure 150 may be etched to expose the plurality of transparent electrode layers 130 in the pixel region PXR. In this regard, by overetching, the exposed parts of the plurality of transparent electrode layers 130 may be partially etched to form the local recess 130R (see FIG. 2A) in the exposed surface of each of the plurality of transparent electrode layers 130.

The plurality of reflective electrode layers 170 covering the local recess 130R of each of the plurality of transparent electrode layers 130 and the peripheral reflective structure 150 and insulating layer 160 may be formed. Each of the plurality of reflective electrode layers 170 may be formed to conformally cover surfaces defining the local recess 130R of the transparent electrode layer 130 and surfaces of the reflective structure 150 and the insulating layer 160 which are adjacent to the local recess 130R.

The second bonding insulating layer 162 covering the plurality of reflective electrode layers 170 and insulating layer 160 in the pixel region PXR and covering the insulating layer 160 in the connection region CR and the contact pad region PAD may be formed. The second bonding insulating layer 162 may be formed to have a flat upper surface.

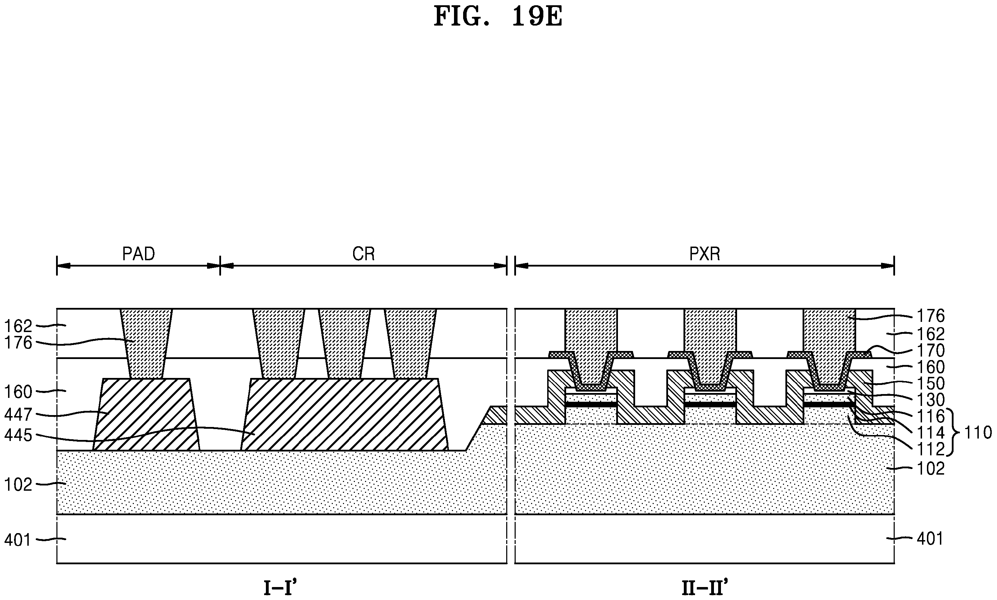

Referring to FIG. 19E, by partially etching the second bonding insulating layer 162 in the pixel region PXR, the connection region CR, and the contact pad region PAD, a plurality of via holes exposing the plurality of reflective electrode layers 170, the common electrode 445, and the inner pad electrode 447 may be formed, and the plurality of second bonding electrodes 176 filling the plurality of via holes may be formed.

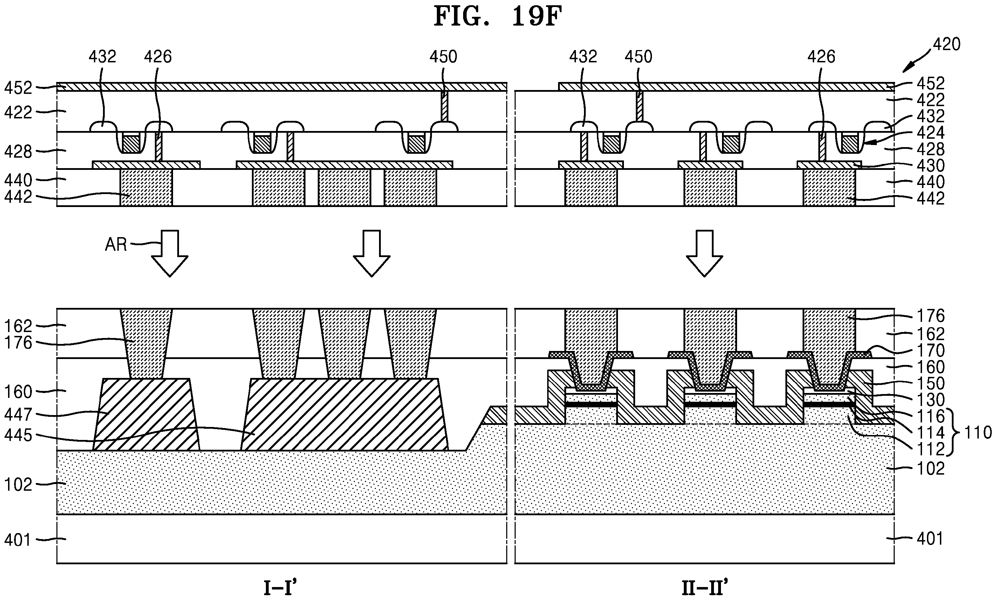

Referring to FIG. 19F, after preparing the circuit board 420, the circuit board 420 may be arranged on the resulting product of FIG. 19E such that the second bonding insulating layer 162 and the plurality of second bonding electrodes 176 are arranged to face the first bonding insulating layer 440 and the plurality of first bonding electrodes 442 which are included in the circuit board 420, and the circuit board 420 may be pressurized in an arrow AR direction on the surface exposing the second bonding insulating layer 162 and the plurality of second bonding electrodes 176 to bond the plurality of first bonding electrodes 442 to the plurality of second bonding electrodes 176 and to bond the first bonding insulating layer 440 to the second bonding insulating layer 162.

The bonding between the plurality of first bonding electrodes 442 and the plurality of second bonding electrodes 176 and the bonding between the first bonding insulating layer 440 and the second bonding insulating layer 162 may be by wafer bonding, for example, the hybrid bonding described above.

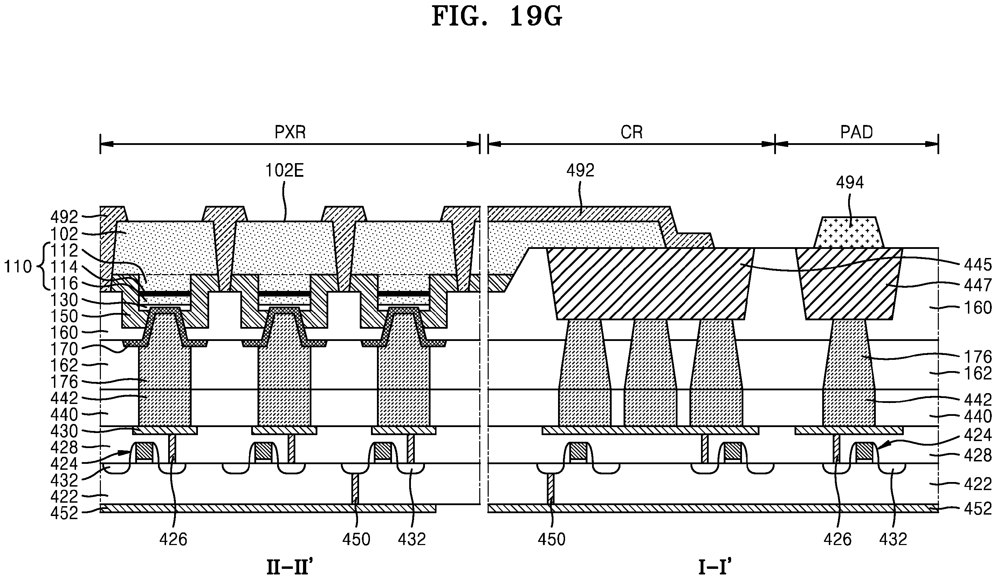

Referring to FIG. 19G, from the resulting product in which the plurality of first bonding electrodes 442 and the plurality of second bonding electrodes 176 are bonded and first bonding insulating layer 440 and the second bonding insulating layer 162 is bonded according to the process described in relation to FIG. 19F, the substrate for growth 401 covering the first conductivity type base semiconductor layer 102 may be removed to expose the first conductivity type base semiconductor layer 102. The substrate for growth 401 may be removed by various processed such as laser lift-off, mechanical polishing, mechanical-chemical polishing, or etching. After the first conductivity type base semiconductor layer 102 is exposed by removing the substrate for growth 401, the thickness of the first conductivity type base semiconductor layer 102 may be reduced by using a polishing process such as chemical mechanical polishing (CMP), etc.

In the connection region CR and the contact pad region PAD, by partially etching the first conductivity type base semiconductor layer 102, a part of the common electrode 445 and the inner pad electrode 447 may be exposed, and in the pixel region PXR, by partially etching the first conductivity type base semiconductor layer 102 and the reflective structure 150, an electrode space in a grid shape or a mesh shape penetrating the first conductivity type base semiconductor layer 102 and the reflective structure 150 may be arranged. By filling a conductive material in the electrode space, the grid electrode 492 may be formed. In the pixel region PXR, the grid electrodes 492 may be formed to be connected to each other in a grid shape or a mesh shape.

The grid electrode 492 may be formed to include a part covering the rear surface 102B of the first conductivity type base semiconductor layer 102 in the pixel region PXR and the connection region CR. The grid electrode 492 may be formed in contact with each of the first conductivity type base semiconductor layer 102 and the common electrode 445 in the connection region CR. A plating process may be used to form the grid electrode 492; however, embodiments are not limited thereto.

As illustrated in FIG. 13, the plurality of microlenses 496 covering the plurality of emission surfaces 102E defined by the grid electrode 492 of the rear surface 102B of the first conductivity type base semiconductor layer 102 may be formed.

In the contact pad region PAD, the contact pad electrode 494 may be formed on the inner pad electrode 447, and by performing dicing in the edge region ISO (see FIG. 11) of each of the plurality of adjacent modules, the display device 400 may be manufactured.

An example of a manufacturing method of the display device 400 illustrated in FIGS. 11, 12, and 13 is described in relation to FIGS. 19A to 19G; however, it may be obvious for a person skilled in the art that the light-emitting device 100, 100A, 100B, 100C, 100D, 100E, 100F, and 200 illustrated in FIGS. 1 to 9B may be manufactured by modifying or altering the method described in relation to FIGS. 19A to 19G within the scope of the present disclosure.

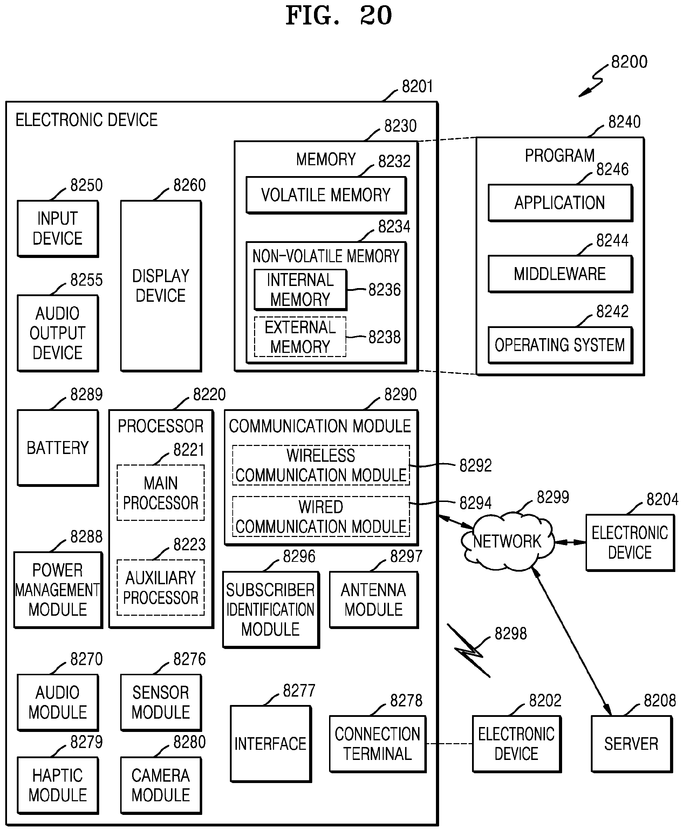

FIG. 20 is a block diagram illustrating an example of an electronic device including a display device.

Referring to FIG. 20, an electronic device 8201 may be provided in a network environment 8200. In the network environment 8200, the electronic device 8201 may communicate with another electronic device 8202 through a first network 8298 (a short-range wireless communication network, etc.) or communicate with another electronic device 8204 and/or a server 8208 through a second network 8299 (a long-distance wireless communication network, etc.). The electronic device 8201 may communicate with the electronic device 8204 through the server 8208. The electronic device 8201 may include a processor 8220, a memory 8230, an input device 8250, an audio output device 8255, a display device 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. In the electronic device 8201, some of the constituent components may be omitted or other constituent components may be added. Some of these components may be implemented as one integrated circuit. For example, the sensor module 8276 (a fingerprint sensor, an iris sensor, an illuminance sensor, and the like) may be implemented by being embedded in the display device 8260 (a display, and the like).

The processor 8220 may control one or a plurality of other constituent elements (hardware and software constituent elements, and the like) of the electronic device 8201 connected to the processor 8220 by executing software (a program 8240, and the like), and perform various data processing or calculations. As part of the data processing or calculations, the processor 8220 may load, in a volatile memory 8232, commands and/or data received from other constituent elements (the sensor module 8276, the communication module 8290, and the like), process the command and/or data stored in the volatile memory 8232, and store result data in a non-volatile memory 8234. The processor 8220 may include a main processor 8221 (a central processing unit, an application processor, and the like) and an auxiliary processor 8223 (a graphics processing unit, an image signal processor, a sensor hub processor, a communication processor, and the like) that is operable independently of or together with the main processor 8221. The auxiliary processor 8223 may use less power than the main processor 8221 and may perform a specialized function.

Instead of the main processor 8221 when the main processor 8221 is in an inactive state (sleep state), or with the main processor 8221 when the main processor 8221 is in an active state (application execution state), the auxiliary processor 8223 may control functions and/or states related to some constituent elements (the display device 8260, the sensor module 8276, the communication module 8290, and the like) of the constituent elements of the electronic device 8201. The auxiliary processor 8223 (an image signal processor, a communication processor, and the like) may be implemented as a part of functionally related other constituent elements (the camera module 8280, the communication module 8290, and the like).

The memory 8230 may store various data needed by the constituent elements (the processor 8220, the sensor module 8276, and the like) of the electronic device 8201. The data may include, for example, software (the program 8240, and the like) and input data and/or output data about commands related thereto. The memory 8230 may include the volatile memory 8232 and/or the non-volatile memory 8234.

The program 8240 may be stored in the memory 8230 as software, and may include an operating system 8242, middleware 8244, and/or an application 8246.

The input device 8250 may receive commands and/or data to be used for constituent elements (the processor 8220, and the like) of the electronic device 8201, from the outside (a user, and the like) of the electronic device 8201. The input device 8250 may include a remote controller, a microphone, a mouse, a keyboard, and/or a digital pen (a stylus pen, and the like).

The audio output device 8255 may output an audio signal to the outside of the electronic device 8201. The audio output device 8255 may include a speaker and/or a receiver. The speaker may be used for general purposes such as multimedia playback or recording playback, and the receiver can be used to receive incoming calls. The receiver may be implemented by being coupled as a part of the speaker or by an independent separate device.

The display device 8260 may visually provide information to the outside of the electronic device 8201. The display device 8260 may include a display, a hologram device, or a projector, and a control circuit to control a corresponding device. The display device 8260 may include the light-emitting device illustrated in FIG. 1 (100, 100A, 100B, 100C, 100D, 100E, 100F, or 200) or the display device 400 illustrated in FIGS. 11, 12, and 13. The display device 8260 may include a touch circuitry set to detect a touch and/or a sensor circuit (a pressure sensor, and the like) set to measure the strength of a force generated by the touch.

The audio module 8270 may convert sound into electrical signals or reversely electrical signals into sound. The audio module 8270 may obtain sound through the input device 8250, or output sound through a speaker and/or a headphone of another electronic device (the electronic device 8202, and the like) connected to the audio output device 8255 and/or the electronic device 8201 in a wired or wireless manner.

The sensor module 8276 may detect an operation state (power, temperature, and the like) of the electronic device 8201, or an external environment state (a user state, and the like), and generate an electrical signal and/or a data value corresponding to a detected state. The sensor module 8276 may include a gesture sensor, a gyro sensor, a barometric pressure sensor, a magnetic sensor, an acceleration sensor, a grip sensor, a proximity sensor, a color sensor, an IR sensor, a biometric sensor, a temperature sensor, a humidity sensor, and/or an illuminance sensor.

The interface 8277 may support one or more specified protocols used for the electronic device 8201 to be connected to another electronic device (the electronic device 8202, and the like) in a wired or wireless manner. The interface 8277 may include a high definition multimedia interface (HDMI), a universal serial bus (USB) interface, an SD card interface, and/or an audio interface.

A connection terminal 8278 may include a connector for the electronic device 8201 to be physically connected to another electronic device (the electronic device 8202, and the like). The connection terminal 8278 may include an HDMI connector, a USB connector, an SD card connector, and/or an audio connector (a headphone connector, and the like).

The haptic module 8279 may convert electrical signals into mechanical stimuli (vibrations, movements, and the like) or electrical stimuli that are perceivable by a user through tactile or motor sensations. The haptic module 8279 may include a motor, a piezoelectric device, and/or an electrical stimulation device.

The camera module 8280 may capture a still image and a video. The camera module 8280 may include a lens assembly including one or more lenses, image sensors, image signal processors, and/or flashes. The lens assembly included in the camera module 8280 may collect light emitted from a subject for image capturing.

The power management module 8288 may manage power supplied to the electronic device 8201. The power management module 8288 may be implemented as a part of a power management integrated circuit (PMIC).

The battery 8289 may supply power to the constituent elements of the electronic device 8201. The battery 8289 may include non-rechargeable primary cells, rechargeable secondary cells, and/or fuel cells.

The communication module 8290 may establish a wired communication channel and/or a wireless communication channel between the electronic device 8201 and another electronic device (the electronic device 8202, the electronic device 8204, the server 8208, and the like), and support a communication through an established communication channel. The communication module 8290 may be operated independent of the processor 8220 (the application processor, and the like), and may include one or more communication processors supporting a wired communication and/or a wireless communication. The communication module 8290 may include a wireless communication module 8292 (a cellular communication module, a short-range wireless communication module, a global navigation satellite system (GNSS) communication module, and the like), and/or a wired communication module 8294 (a local area network (LAN) communication module, a power line communication module, and the like). Among the above communication modules, a corresponding communication module may communicate with another electronic device through the first network 8298 (a short-range communication network such as Bluetooth, WiFi Direct, or infrared data association (IrDA)) or the second network 8299 (a long-range communication network such as a cellular network, the Internet, or a computer network (LAN, WAN, and the like)). These various types of communication modules may be integrated into one constituent element (a single chip, and the like), or may be implemented as a plurality of separate constituent elements (multiple chips). The wireless communication module 8292 may verify and authenticate the electronic device 8201 in a communication network such as the first network 8298 and/or the second network 8299 by using subscriber information (an international mobile subscriber identifier (IMSI), and the like) stored in the subscriber identification module 8296.

The antenna module 8297 may transmit signals and/or power to the outside (another electronic device, and the like) or receive signals and/or power from the outside. An antenna may include an emitter formed in a conductive pattern on a substrate (a printed circuit board (PCB), and the like). The antenna module 8297 may include one or a plurality of antennas. When the antenna module 8297 includes a plurality of antennas, the communication module 8290 may select, from among the antennas, an appropriate antenna for a communication method used in a communication network such as the first network 8298 and/or the second network 8299. Signals and/or power may be transmitted or received between the communication module 8290 and another electronic device through the selected antenna. Other parts (an RFIC, and the like) than the antenna may be included as a part of the antenna module 8297.

Some of the constituent components of the electronic device 8201 may be connected to each other through a communication method between peripheral devices (a bus, a general purpose input and output (GPIO), a serial peripheral interface (SPI), a mobile industry processor interface (MIPI), and the like) and may mutually exchange signals (commands, data, and the like).

The command or data may be transmitted or received between the electronic device 8201 and the external electronic device 8204 through the server 8208 connected to the second network 8299. The electronic devices 8202 and 8204 may be of a type that is the same as or different from the electronic device 8201. All or a part of operations executed in the electronic device 8201 may be executed in one or more electronic devices (8202, 8204, and 8208). For example, when the electronic device 8201 needs to perform a function or service, the electronic device 8201 may request one or more electronic devices to perform part of the whole of the function or service, instead of performing the function or service. The one or more electronic devices receiving the request may perform additional function or service related to the request, and transmit a result of the performance to the electronic device 8201. To this end, cloud computing, distributed computing, and/or client-server computing technology may be used.

The electronic device 8201 may be applied to various devices. Various components of the electronic device 8201 may be modified according to a function of the device, and other components suitable for performing the function of the device may be further added. Hereinafter, application examples of the electronic device 8201 are described.

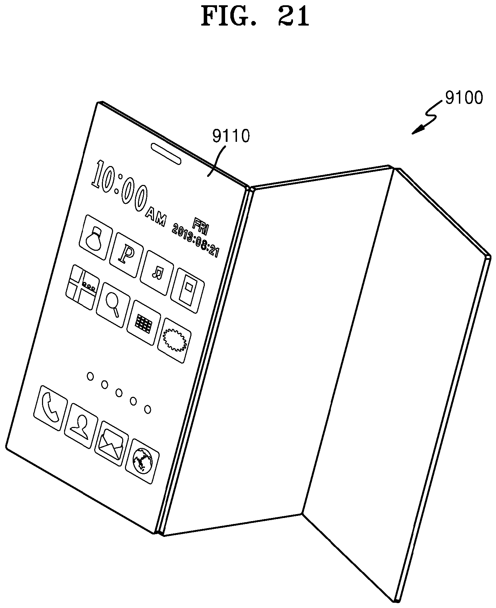

FIG. 21 is a diagram illustrating an example of a mobile device as an application example of the electronic device. A mobile device 9100 may include a display device 9110. The display device 9110 may include the light-emitting device illustrated in FIG. 1 (100, 100A, 100B, 100C, 100D, 100E, 100F, or 200) or the display device 400 illustrated in FIGS. 11, 12, and 13. The display device 9110 may have a foldable structure, for example, a multi-foldable structure.

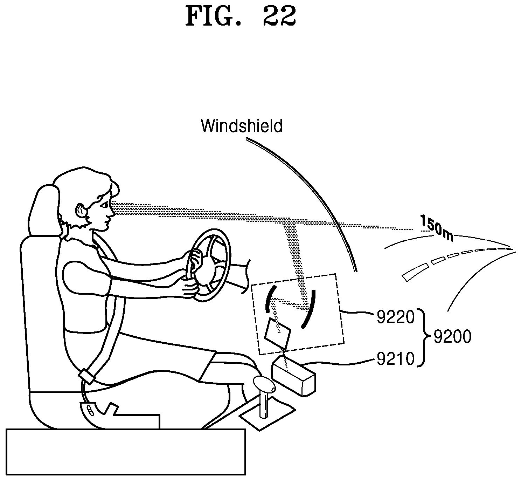

FIG. 22 is a diagram illustrating an example of a head-up display device for vehicles as an application example of the electronic device. The head-up display device 9200 for vehicles may include a display 9210 provided in an area of a vehicle and an optical path change member 9220 configured to change an optical path such that a driver can see an image generated at the display 9210. The display 9210 may include the light-emitting device illustrated in FIG. 1 (100, 100A, 100B, 100C, 100D, 100E, 100F, or 200) or the display device 400 illustrated in FIGS. 11, 12, and 13.

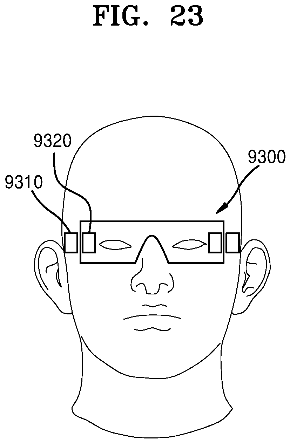

FIG. 23 is a diagram illustrating an example of augmented reality glasses or virtual reality glasses as an application example of the electronic device. Augmented reality glasses (or virtual reality glasses) 9300 may include a projection system 9310 configured to form an image and a guide element 9320 configured to guide the image from the projection system 9310 to user's eyes. The projection system 9310 may include the light-emitting device illustrated in FIG. 1 (100, 100A, 100B, 100C, 100D, 100E, 100F, or 200) or the display device 400 illustrated in FIGS. 11, 12, and 13.

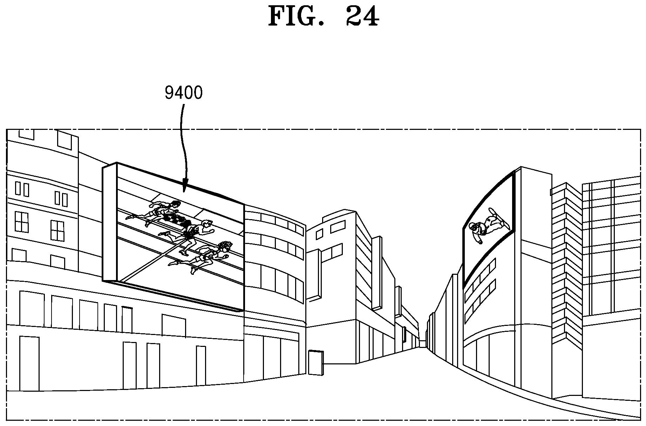

FIG. 24 is a diagram illustrating an example of a large-scale signage as an application example of the electronic device. A signage 9400 may include the display described in relation to FIG. 12. The signage 9400 may include the light-emitting device illustrated in FIG. 1 (100, 100A, 100B, 100C, 100D, 100E, 100F, or 200) or the display device 400 illustrated in FIGS. 11, 12, and 13. The signage 9400 may be used in outdoor advertising using a digital information display, and may control contents, etc. of an advertisement though a network. The signage 9400 may be implemented by, for example, the electronic device described with reference to FIG. 20.

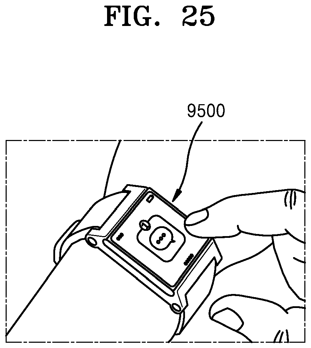

FIG. 25 is a diagram illustrating an example of a wearable display as an application example of the electronic device. A wearable display 9500 may include the light-emitting device illustrated in FIG. 1 (100, 100A, 100B, 100C, 100D, 100E, 100F, or 200) or the display device 400 illustrated in FIGS. 11, 12, and 13. The wearable display 9500 may be implemented through the electronic device described in relation to FIG. 20.

The light-emitting device (100, 100A, 100B, 100C, 100D, 100E, 100F, or 200) illustrated in FIGS. 1 to 9B and the display device 400 illustrated in FIGS. 11, 12, and 13 may be applied to various products, such as a rollable television, a stretchable display, etc., in addition to the electronic devices described above.

While aspects of embodiments have been particularly shown and described, it will be understood that various changes in form and details may be made therein without departing from the scope of the following claims.

## Claims

1. A light-emitting device comprising:
a semiconductor light-emitting structure (110; 110A; 110B; 110C; 210) comprising a first conductivity type semiconductor layer (112; 112A), an active layer (114; 114A; 214), and a second conductivity type semiconductor layer (116; 116A) which are sequentially provided in a first direction (Z); and
an electrode layer (130, 170; 130D, 170) covering the second conductivity type semiconductor layer (116; 116A) and spaced apart from the active layer (114; 114A; 214) in the first direction (X) with the second conductivity type semiconductor layer (116; 116A) therebetween,
wherein the semiconductor light-emitting structure (110; 110A; 110B; 110C; 210) is configured to emit light having a wavelength λ within a range from about 490 nm to about 700 nm, and
wherein a minimum distance from the electrode layer (130; 130D) to the active layer (114; 114A; 214) in the first direction (Z) is greater than about 0.05λ and less than about 0.24λ.

2. The light-emitting device of claim 1, wherein the second conductivity type semiconductor layer (116; 116A) comprises a first surface in contact with the active layer (114; 114A; 214) and a second surface in contact with the electrode layer (130; 130D), and the second surface is opposite to the first surface in the first direction (Z), and
wherein a thickness (116T) of the second conductivity type semiconductor layer (116; 116A) in the first direction (Z) is greater than about 0.05λ and less than about 0.24λ.

3. The light-emitting device of claim 1 or 2, wherein the electrode layer (130; 130D) comprises:
a transparent electrode layer (130; 130D) in contact with the second conductivity type semiconductor layer (116; 116A); and
a reflective electrode layer (170) in contact with the transparent electrode layer (130; 130D) and spaced apart from the second conductivity type semiconductor layer (116; 116A) in the first direction (Z) with the transparent electrode layer (130; 130D) therebetween.

4. The light-emitting device of any one of claims 1 to 3, wherein the active layer (114; 114A; 214) comprises a first surface in contact with the first conductivity type semiconductor layer (112; 112A) and a second surface in contact with the second conductivity type semiconductor layer (116; 116A), and
wherein a minimum distance from the first surface to the second surface in the first direction (Z) is less than 300 nm.

5. The light-emitting device of any one of claims 1 to 4, wherein a thickness of the active layer (114; 114A; 214) in the first direction (Z) is less than 0.4λ.

6. The light-emitting device of any one of claims 1 to 5, wherein the wavelength λ is within a range from about 610 nm to about 650 nm.

7. The light-emitting device of any one of claims 1 to 5, wherein the wavelength λ is within a range from about 510 nm to about 550 nm.

8. The light-emitting device of any one of claims 1 to 7, wherein the active layer (114; 114A) comprises a multi-quantum well layer comprising a first surface in contact with the first conductivity type semiconductor layer (112; 112A) and a second surface in contact with the second conductivity type semiconductor layer (116; 116A), and
wherein a thickness of the multi-quantum well layer in the first direction (Z) is less than 300 nm.

9. The light-emitting device of any one of claims 1 to 7, wherein the active layer (214) comprises:
a first multi-quantum well layer (214A) comprising a first surface in contact with the first conductivity type semiconductor layer (112);
a second multi-quantum well layer (214C) comprising a second surface in contact with the second conductivity type semiconductor layer (116) and spaced apart from the first multi-quantum well layer (214A) in the first direction (Z); and
a spacer barrier layer (214B) between the first multi-quantum well layer (214A) and the second multi-quantum well layer (214C), and
wherein in the first direction (Z), a thickness (BT1; BT2; BT3) of the spacer barrier layer (214B) is greater than each of a thickness (CTR2; CTG2; CTB2) of the first multi-quantum well layer (214A) and a thickness (CTR1; CTG1; CTB1) of the second multi-quantum well layer (214C).

10. The light-emitting device of claim 9, wherein at least one constituent material of the spacer barrier layer (214B) is identical to at least one constituent material provided in the first multi-quantum well layer (214A) and the second multi-quantum well layer (214C), and
wherein in the first direction (Z), each of the thickness (CTR2; CTG2; CTB2) of the first multi-quantum well layer (214A) and the thickness (CTR1; CTG1; CTB1) of the second multi-quantum well layer (214C) is less than 300 nm.

11. The light-emitting device of any one of claims 1 to 10, wherein the active layer (114; 114A; 214) has a quantum well structure comprising a pair structure of a quantum well layer and a quantum barrier layer in 1 to 15 cycles, and
wherein the pair structure in the quantum well structure is selected from InGaN/GaN, InGaN/InGaN, InGaN/AlGaN, and InGaN/InAlGaN.

12. The light-emitting device of any one of claims 1 to 11, wherein the semiconductor light-emitting structure has a width (110W) less than 100 µm in a second direction (X) perpendicular to the first direction (Z).

13. The light-emitting device of any one of claims 1 to 12, further comprising a reflective structure (150) covering a side wall of each of the first conductivity type semiconductor layer (112; 112A), the active layer (114; 114A; 214), and the second conductivity type semiconductor layer (116; 116A) which are provided in the semiconductor light-emitting structure (110; 110A; 110B; 110C; 210),
wherein the reflective structure comprises a distributed Bragg reflector, DBR.

14. The light-emitting device of any one of claims 1 to 12, further comprising a reflective structure (150E) covering a side wall of each of the first conductivity type semiconductor layer (112), the active layer (114), and the second conductivity type semiconductor layer (116) which are provided in the semiconductor light-emitting structure (110),
wherein the reflective structure (150E) comprises a metal.

15. The light-emitting device of any one of claims 1 to 14, further comprising:
a first conductivity type base semiconductor layer (102) integrally connected to the first conductivity type semiconductor layer (112; 112A) and spaced apart from the active layer (114; 114A; 214) in the first direction (Z) with the first conductivity type semiconductor layer (112; 112A) therebetween; and
a microlens (190) spaced apart from the first conductivity type semiconductor layer (112; 112A) in the first direction (Z) with the first conductivity type base semiconductor layer (102) therebetween and configured to collect and emit light from the semiconductor light-emitting structure (110; 110A; 110B; 110C; 210).
